# EUROPEAN PATENT APPLICATION

(11) **EP 1 596 429 A1**
(43) Date of publication of application: **16.11.2005**
(21) Application number: 04711033.3
(22) Date of filing: 13.02.2004
(51) Int. Cl.: H01L 21/66, G01R 1/06, H01R 11/01

(54) **ANISOTROPIC CONDUCTIVE CONNECTOR AND PROBE MEMBER AND WAFER INSPECTING DEVICE AND WAFER INSPECTING METHOD**

(30) Priority: 18.02.2003 JP 2003040026
(71) Applicant: JSR Corporation, Tokyo 104-0045 (JP)
(72) Inventor: Naoi, Masaya, c/o JSR Corporation, Tokyo 1040045 (JP)
(74) Representative: TBK-Patent
(86) International application number: PCT/JP2004/001550
(87) International publication number: WO 2004/075283

(57) **Abstract**

Disclosed herein are an anisotropically conductive connector, by which positioning, and holding and fixing to a wafer that is an object of inspection can be conducted with ease even when the wafer has a large area of 8 inches or greater in diameter, and the pitch of electrodes to be inspected in integrated circuits formed is small, good conductivity is surely achieved as to all conductive parts for connection, at the same time, insulating property between adjoining conductive parts for connection is surely attained, and moreover the good conductivity is retained over a long period of time even when it is used repeatedly, and applications thereof.

The anisotropically conductive connector of the present invention comprises elastic anisotropically conductive films each having a functional part, in which a plurality of conductive parts for connection containing conductive particles and extending in a thickness-wise direction of the film have been arranged in a state mutually insulated by an insulating part wherein assuming that a thickness of the conductive parts for connection in the functional part of the elastic anisotropically conductive film is T1 and a thickness of the insulating part in the functional part is T2, a ratio (T2/T1) is at least 0.9.

## Description

### TECHNICAL FIELD

The present invention relates to an anisotropically conductive connector suitable for use in conducting electrical inspection of a plurality of integrated circuits formed on a wafer in a state of the wafer, a probe member equipped with this anisotropically conductive connector, a wafer inspection apparatus equipped with this probe member, and a wafer inspection method using this probe member, and particularly to an anisotropically conductive connector suitable for use in conducting electrical inspection of integrated circuits, which are formed on a wafer having a diameter of, for example, 8 inches or greater and have at least 5,000 electrodes to be inspected in total, in a state of the wafer, a probe member equipped with this anisotropically conductive connector, a wafer inspection apparatus equipped with this probe member, and a wafer inspection method using this probe member.

### BACKGROUND ART

In the production process of semiconductor integrated circuit devices, after a great number of integrated circuits are formed on a wafer composed of, for example, silicon, a probe test for sorting defective integrated circuits by inspecting basic electrical properties of each of these integrated circuits is generally conducted. This wafer is then cut, thereby forming semiconductor chips. Such semiconductor chips are contained and sealed in respective proper packages. Each of the packaged semiconductor integrated circuit devices is further subjected to a burn-in test for sorting semiconductor integrated circuit devices having latent defects by inspecting electrical properties under a high-temperature environment.

In such electrical inspection of integrated circuits, such as probe test or burn-in test, a probe member is in use for electrically connecting each of electrodes to be inspected in an object of inspection to a tester. As such a probe member, is known a member composed of a circuit board for inspection, on which inspection electrodes have been formed in accordance with a pattern corresponding to a pattern of electrodes to be inspected, and an anisotropically conductive elastomer sheet arranged on this circuit board for inspection.

As such anisotropically conductive elastomer sheets, those of various structures have heretofore been known. For example, the following Prior Art. 1 discloses an anisotropically conductive elastomer sheet (hereinafter referred to as "dispersion type anisotropically conductive elastomer sheet") obtained by uniformly dispersing metal particles in an elastomer, and the following Prior Art. 2 discloses an anisotropically conductive elastomer sheet (hereinafter referred to as "uneven distribution type anisotropically conductive elastomer sheet") obtained by unevenly distributing particles of a conductive magnetic substance in an elastomer to form a great number of conductive parts extending in a thickness-wise direction thereof and an insulating part for mutually insulating them. Further, the following Prior Art. 3 discloses an uneven distribution type anisotropically conductive sheet with a difference in level defined between the surfaces of conductive parts and an insulating part.

In the uneven distribution type anisotropically conductive elastomer sheet, since the conductive parts are formed in accordance with a pattern corresponding to a pattern of electrodes to be inspected of an integrated circuit to be inspected, it is advantageous compared with the dispersion type anisotropically conductive elastomer sheet in that electrical connection between electrodes can be achieved with high reliability even to an integrated circuit small in the arrangement pitch of electrodes to be inspected, i.e., center distance between adjacent electrodes to be inspected. Among the uneven distribution type anisotropically conductive elastomer sheets, that having conductive parts formed in a state projected from the surface of an insulating part is advantageous in that high conductivity is attained with small pressurizing force.

In such an uneven distribution type anisotropically conductive elastomer sheet, it is necessary to hold and fix it in a particular positional relation to a circuit board for inspection and an object of inspection in an electrically connecting operation to them.

The anisotropically conductive elastomer sheet is flexible and easy to be deformed, and so it is low in handling property. In addition, with the miniaturization or high-density wiring of electric products in recent years, integrated circuit devices used therein tend to arrange electrodes at a high density as the number of electrodes increases, and the arrangement pitch of the electrodes becomes smaller. Therefore, the positioning and the holding and fixing of the uneven distribution type anisotropically conductive elastomer sheet are becoming to be difficult upon its electrical connection to electrodes to be inspected of the object of inspection.

In the burn-in test, there is a problem that even when the necessary positioning, and holding and fixing of the uneven distribution type anisotropically conductive elastomer sheet to an integrated circuit device has been realized once, positional deviation between conductive parts of the uneven distribution type anisotropically conductive elastomer sheet and electrodes to be inspected of the integrated circuit device occurs when they are subjected to thermal hysteresis by temperature change, since a coefficient of thermal expansion is greatly different between a material (for example, silicon) making up the integrated circuit device that is the object of inspection, and a material (for example, silicone rubber) making up the uneven distribution type anisotropically conductive elastomer sheet, as a result, the electrically connected state is changed, and thus the stably connected state is not retained.

In order to solve such a problem, an anisotropically conductive connector composed of a metal-made frame plate having an opening and an anisotropically conductive sheet arranged in the opening of this frame plate and supported at its peripheral edge by an opening edge about the frame plate has been proposed (see, for example, the following Prior Art. 4).

This anisotropically conductive connector is generally produced in the following manner.

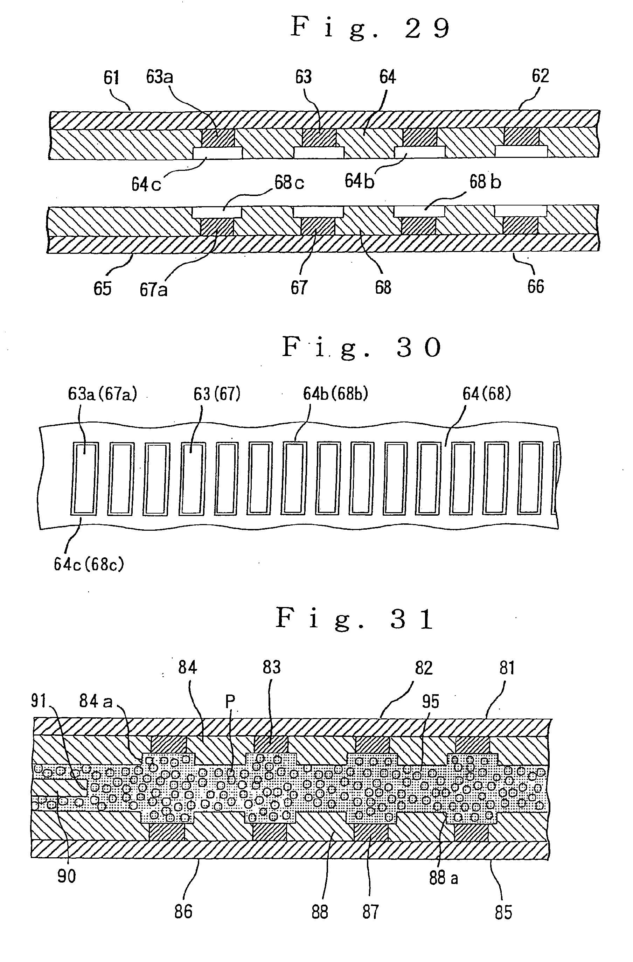

As illustrated in Fig. 31, a mold for molding an anisotropically conductive elastomer sheet composed of a top force 81 and a bottom force 85 making a pair therewith are provided, a frame plate 90 having an opening 91 is arranged in alignment in this mold, and a molding material with conductive particles exhibiting magnetism dispersed in a polymeric substance-forming material, which will become an elastic polymeric substance by a curing treatment, is fed into a region including the opening 91 of the frame plate 90 and an opening edge thereabout to form a molding material layer 95. Here, the conductive particles P contained in the molding material layer 95 are in a state dispersed in the molding material layer 95.

In each of the top force 81 and bottom force 85 in the mold, a plurality of ferromagnetic substance layers 83 or 87 are formed, on a base plate 82 or 86 composed of, for example, a ferromagnetic substance, in accordance with a pattern corresponding to a pattern of conductive parts of an anisotropically conductive elastomer sheet to be molded, and non-magnetic substance layers 84 or 88 are formed at other potions than the portions at which the ferromagnetic substance layers 83 or 87 have been formed. A molding surface is formed by the ferromagnetic substance layers 83 or 87 and the non-magnetic substance layers 84 or 88. Recessed parts 84a and 88a for forming projected parts on the anisotropically conductive elastomer sheet are formed in positions of the molding surfaces of the top force 81 and bottom force 85, at which the ferromagnetic substance layers 83 and 87 are respectively located. The top force 81 and bottom force 85 are arranged in such a manner that their corresponding ferromagnetic substance layers 83 and 87 are opposed to each other.

A pair of, for example, electromagnets are then arranged on an upper surface of the top force 81 and a lower surface of the bottom force 85, and the electromagnets are operated, thereby applying a magnetic field having higher intensity at portions between ferromagnetic substance layers 83 of the top force 81 and their corresponding ferromagnetic substance layers 87 of the bottom force 85, i.e., portions to become conductive parts, than the other portions, to the molding material layer 95 in the thickness-wise direction of the molding material layer 95. As a result, the conductive particles P dispersed in the molding material layer 95 are gathered at the portions where the magnetic field having the higher intensity is applied in the molding material layer 95, i.e., the portions between the ferromagnetic substance layers 83 of the top force 81 and their corresponding ferromagnetic substance layers 87 of the bottom force 85, and further oriented so as to align in the thickness-wise direction. In this state, the molding material layer 95 is subjected to a curing treatment, whereby an anisotropically conductive elastomer sheet composed of a plurality of conductive parts, in which the conductive particles P are contained in a state oriented so as to align in the thickness-wise direction, and an insulating part for mutually insulating these conductive parts, and having projected parts that the conductive parts are protruding from the surface of the insulating part is molded in a state that its peripheral edge has been supported by the opening edge about the frame plate, thus producing an anisotropically conductive connector.

According to such an anisotropically conductive connector, it is hard to be deformed and easy to handle because the anisotropically conductive elastomer sheet is supported by the metal-made frame plate. A positioning mark (for example, a hole) is formed in the frame plate in advance, whereby the positioning and the holding and fixing to an integrated circuit device can also be easily conducted upon an electrically connecting operation to the integrated circuit device. In addition, a material low in coefficient of thermal expansion is used as a material for forming the frame plate, whereby the thermal expansion of the anisotropically conductive sheet is restrained by the frame plate, so that positional deviation between the conductive parts of the uneven distribution type anisotropically conductive elastomer sheet and electrodes to be inspected of the integrated circuit device is prevented even when they are subjected to thermal hysteresis by temperature change. As a result, a good electrically connected state can be stably retained.

By the way, in a probe test conducted for integrated circuits formed on a wafer, a method that a probe test is collectively performed on a group of integrated circuits composed of 16 or 32 integrated circuits among a great number of integrated circuits formed on a wafer, and the probe test is successively performed on other groups of integrated circuits has heretofore been adopted.

In recent years, there has been a demand for collectively performing a probe test on, for example, 64 or 124 integrated circuits among a great number of integrated circuits formed on a wafer, or all the integrated circuits for the purpose of improving inspection efficiency and reducing inspection cost.

In a burn-in test on the other hand, it takes a long time to individually conduct electrical inspection of a great number of integrated circuit devices because each integrated circuit device that is an object of inspection is fine, and its handling is inconvenient, whereby inspection cost becomes considerably high. From such reasons, there has been proposed a WLBI (Wafer Lebel Burn-in) test in which the burn-in test is collectively performed on a great number of integrated circuits formed on a wafer in the state of the wafer.

When a wafer that is an object of inspection is of large size of, for example, at least 8 inches in diameter, and the number of electrodes to be inspected formed thereon is, for example, at least 5,000, particularly at least 10,000, however, the following problems are involved when the above-described anisotropically conductive connector is applied as a probe member for the probe test or WLBI test, since a pitch between electrodes to be inspected in each integrated circuit is extremely small.

In other words, in order to inspect a wafer having a diameter of, for example, 8 inches (about 20 cm), it is necessary to use an anisotropically conductive elastomer sheet having a diameter of about 8 inches as an anisotropically conductive connector. However, such an anisotropically conductive elastomer sheet is large in the whole area, but each conductive part is fine, and the area proportion of the surfaces of the conductive parts to the whole surface of the anisotropically conductive elastomer sheet is low. It is therefore extremely difficult to surely produce such an anisotropically conductive elastomer sheet.

In addition, since the conductive parts to be formed are fine and extremely small in pitch, it is difficult to surely produce anisotropically conductive elastomer sheet having necessary insulating property between adjoining conductive parts. This is considered to be attributable to the following reasons.

As described above, the magnetic field having intensity distribution is applied to the molding material layer with the conductive particles exhibiting magnetism dispersed in the polymeric substance-forming material in the thickness-wise direction thereof upon the production of the anisotropically conductive elastomer sheet, thereby forming portions, in which the conductive particles are densely gathered, and portions in which the conductive particles are sparse, and such a molding material layer is subjected to the curing treatment, thereby forming conductive parts, in which the conductive particles are densely contained, and an insulating part, in which the conductive particles are not contained at all or scarcely contained.

When an anisotropically conductive elastomer sheet adapting to a wafer having a diameter of 8 inches or greater and at least 5,000 electrodes to be inspected is produced, however, the conductive particles are hard to be gathered to expected portions even when the above-described mold is used, and the magnetic field having the intensity distribution is applied to the molding material layer, since magnetic fields by adjoining ferromagnetic substance layers influence each other. When an anisotropically conductive elastomer sheet having projected parts is produced in particular, the movement of the conductive particles in a lateral direction is inhibited by the recessed parts formed in the molding surfaces of the mold, so that the conductive particles are harder to be gathered at the expected portions.

Accordingly, in the resulting anisotropically conductive elastomer sheet, the conductive particles are not filled in a necessary amount in the conductive parts, whereby not only the conductivity of the conductive parts is deteriorated, but also the conductive particles remain in the insulating part, so that an electric resistance value between adjoining conductive parts is lowered to make it difficult to secure necessary insulating property between the adjoining conductive parts.

A wafer, on which integrated circuits having projected electrodes (bumps) have been formed, has been recently produced, and electrical inspection of the integrated circuits formed on this wafer is conducted in the production process thereof.

When the anisotropically conductive elastomer sheet having the projected parts is used in the electrical inspection of such a wafer, however, the anisotropically conductive elastomer sheet involves a problem that its durability over repeated use is lowered.

More specifically, an operation that projected electrodes, which are electrodes to be inspected in the wafer that is an object of inspection, are brought into contact under pressure with the conductive parts of the anisotropically conductive elastomer sheet is conducted repeatedly, whereby the projected parts of the conductive parts are crashed in the early stage, and permanent deformation occurs in the conductive parts, so that stable electrical connection is not attained between the conductive parts and the electrodes to be inspected.

Methods for conducting a probe test as to integrated circuits formed at a high degree of integration on a wafer having a diameter of 8 inches or 12 inches include a method that the wafer is divided into 2 or more areas to collectively perform the probe test as to the integrated circuits formed in each of the divided areas in addition to a method of collectively conducting the probe test as to all the integrated circuits formed on the wafer. An anisotropically conductive connector used in such a method is desired to have high durability over repeated use for the purpose of reducing inspection cost.
- Prior Art. 1:: Japanese Patent Application Laid-Open No. 93393/1976;
- Prior Art. 2:: Japanese Patent Application Laid-Open No. 147772/1978;
- Prior Art. 3:: Japanese Patent Application Laid-Open No. 250906/1986;
- Prior Art. 4:: Japanese Patent Application Laid-Open No. 40224/1999.

### DISCLOSURE OF THE INVENTION

The present invention has been made on the basis of the foregoing circumstances and has as its first object the provision of an anisotropically conductive connector, by which positioning, and holding and fixing to a wafer that is an object of inspection can be conducted with ease even when the wafer has a large area of, for example, 8 inches or greater in diameter, and the pitch of electrodes to be inspected in integrated circuits formed is small, good conductivity is surely achieved as to all conductive parts for connection, insulating property between adjoining conductive parts for connection is surely attained, and moreover the good conductivity is retained over a long period of time even when it is used repeatedly.

A second object of the present invention is to provide an anisotropically conductive connector that good conductivity is achieved as to conductive parts for connection even when it is pressurized under a small load, in addition to the above object.

A third object of the present invention is to provide an anisotropically conductive connector that a good electrically connected state is stably retained even by environmental changes such as thermal hysteresis by temperature change, in addition to the above objects.

A fourth object of the present invention is to provide a probe member, by which positioning, and holding and fixing to a wafer that is an object of inspection can be conducted with ease even when the wafer has a large area of, for example, 8 inches or greater in diameter, and the pitch of electrodes to be inspected in integrated circuits formed is small, and moreover reliability on connection to each electrode to be inspected is high, and good conductivity is retained over a long period of time even when it is used repeatedly.

A fifth object of the present invention is to provide an anisotropically conductive connector and a probe member, which have high durability in repeated use even when a probe test is performed as to integrated circuits formed at a high degree of integration on a wafer having a diameter of 8 inches or 12 inches.

A sixth object of the present invention is to provide an anisotropically conductive connector and a probe member, which have high durability in repeated use when electrical inspection is performed as to integrated circuits having projected electrodes formed at a high degree of integration on a large-area wafer.

A seventh object of the present invention is to provide a wafer inspection apparatus and a wafer inspection method for conducting electrical inspection of a plurality of integrated circuits formed on a wafer in a state of the wafer using the above-described probe member.

According to the present invention, there is provided an anisotropically conductive connector comprising elastic anisotropically conductive films each having a functional part, in which a plurality of conductive parts for connection containing conductive particles and extending in a thickness-wise direction of the film have been arranged in a state mutually insulated by an insulating part,
wherein assuming that a thickness of the conductive parts for connection in the functional part of the elastic anisotropically conductive film is T1 and a thickness of the insulating part in the functional part is T2, a ratio (T2/T1) is at least 0.9.

According to the present invention, there is also provided an anisotropically conductive connector suitable for use in conducting electrical inspection of each of a plurality of integrated circuits formed on a wafer in a state of the wafer, which comprises:
a frame plate, in which a plurality of anisotropically conductive film-arranging holes each extending through in a thickness-wise direction of the frame plate have been formed corresponding to electrode regions, in which electrodes to be inspected have been arranged, in all or part of the integrated circuits formed on the wafer, which is an object of inspection, and a plurality of elastic anisotropically conductive films arranged in the respective anisotropically conductive film-arranging holes in this frame plate and each supported by the peripheral part about the anisotropically conductive film-arranging hole,
wherein each of the elastic anisotropically conductive films is equipped with a functional part having a plurality of conductive parts for connection arranged corresponding to the electrodes to be inspected in the integrated circuits formed on the wafer, which is the object of inspection, containing conductive particles exhibiting magnetism at a high density and extending in a thickness-wise direction of the film, and an insulating part mutually insulating these conductive parts for connection, and
wherein assuming that a thickness of the conductive parts for connection in the functional part of the elastic anisotropically conductive film is T1 and a thickness of the insulating part in the functional part is T2, a ratio (T2/T1) is at least 0.9.

In such an anisotropically conductive connector, at least one surface of the functional part in each of the elastic anisotropically conductive films may preferably be flat.

It may be preferable that said at least one flat surface of the functional part in each of the elastic anisotropically conductive films be formed so as to project from any other portion, and
assuming that a sum total of areas of one surfaces of the functional parts of all the elastic anisotropically conductive films is S1, and an area of a surface of the wafer, which is the object of inspection, on a side that the electrodes to be inspected have been formed, is S2, a ratio S1/S2 be 0.001 to 0.3.

The coefficient of linear thermal expansion of the frame plate may preferably be at most 3 x 10⁻⁵/K.

According to the present invention, there is further provided a probe member suitable for use in conducting electrical inspection of each of a plurality of integrated circuits formed on a wafer in a state of the wafer, which comprises:
a circuit board for inspection, on the surface of which inspection electrodes have been formed in accordance with a pattern corresponding to a pattern of electrodes to be inspected of the integrated circuits formed on the wafer, which is an object of inspection, and the above-described anisotropically conductive connector having the frame plate and arranged on the surface of the circuit board for inspection.

In the probe member according to the present invention, it may be preferable that the coefficient of linear thermal expansion of the frame plate in the anisotropically conductive connector be at most 3 x 10⁻⁵/K, and the coefficient of linear thermal expansion of a base material making up the circuit board for inspection be at most 3 x 10⁻⁵/K.

In the probe member, a sheet-like connector composed of an insulating sheet and a plurality of electrode structures each extending through the insulating sheet in a thickness-wise direction thereof and arranged in accordance with a pattern corresponding to the pattern of the electrodes to be inspected may be arranged on the anisotropically conductive connector.

According to the present invention, there is still further provided a wafer inspection apparatus for conducting electrical inspection of each of a plurality of integrated circuits formed on a wafer in a state of the wafer, which comprises:
the probe member described above, wherein electrical connection to the integrated circuits formed on the wafer, which is an object of inspection, is achieved through the probe member.

According to the present invention, there is yet still further provided a wafer inspection method comprising a step of electrically connecting each of a plurality of integrated circuits formed on a wafer to a tester through the probe member described above to perform electrical inspection of the integrated circuits formed on the wafer.

### EFFECTS OF THE INVENTION

According to the anisotropically conductive connectors of the present invention, a part to be supported is formed at the peripheral edge of the functional part having the conductive parts for connection in each of the elastic anisotropically conductive films, and this part to be supported is fixed to the periphery about the anisotropically conductive film-arranging hole in the frame plate, so that the anisotropically conductive connectors are hard to be deformed and easy to handle, and the positioning and the holding and fixing to a wafer, which is an object of inspection, can be easily conducted in an electrically connecting operation to the wafer.

In addition, there is no or little difference in thickness between the conductive parts for connection and the insulating part in the functional part of each of the elastic anisotropically conductive films, so that the mold used in the formation of the elastic anisotropically conductive films has a flat molding surface or a molding surface small in the depth of the recessed parts, and so the movement of the conductive particles is not inhibited when the magnetic field is applied to the molding material layers, and the conductive particles can be easily gathered to portions to become the conductive parts for connection almost without remaining at a portion to become the insulating part in the molding material layer. As a result, good conductivity is surely achieved as to all the conductive parts for connection formed and sufficient insulating property is surely attained between adjoining conductive parts for connection.

Further, there is no or little difference in height level between the conductive parts for connection and the insulating part in the surface of the functional part of each of the anisotropically conductive films, so that the occurrence of permanent deformation of the conductive parts for connection due to crush of the projected parts thereof is avoided or inhibited even when a wafer, which is an object of inspection, has projected electrodes to be inspected, and so high durability over repeated use is attained.

According to the construction that one flat surface of the functional part is formed so as to project from any other portion, and the ratio of the area of one surfaces of the functional parts to the area of surface of the wafer, which is the object of inspection, falls within a specified range, a load is applied concentratedly only to the functional parts when the anisotropically conductive connector is pressurized in a thickness-wise direction, so that good conductivity is surely achieved on the conductive parts for connection even when the anisotropically conductive connector is pressurized under a small load.

Since the respective anisotropically conductive film-arranging holes in the frame plate are formed corresponding to the electrode regions, in which electrodes to be inspected have been formed, of integrated circuits in a wafer, which is an object of inspection, and the elastic anisotropically conductive film arranged in each of the anisotropically conductive film-arranging holes may be small in area, the individual elastic anisotropically conductive films are easy to be formed. In addition, since the elastic anisotropically conductive film small in area is little in the absolute quantity of thermal expansion in a plane direction of the elastic anisotropically conductive film even when it is subjected to thermal hysteresis, the thermal expansion of the elastic anisotropically conductive film in the plane direction is surely restrained by the frame plate by using a material having a low coefficient of linear thermal expansion as that for forming the frame plate. Accordingly, a good electrically connected state can be stably retained even when the WLBI test is performed on a large-area wafer.

According to the probe members of the present invention, positioning, and holding and fixing to a wafer, which is an object of inspection, can be conducted with ease in an electrically connecting operation to the wafer, and moreover the necessary conductivity can be retained over a long period of time even when they are used repeatedly in inspection of wafers, on which integrated circuits having projected electrodes have been formed.

According to the wafer inspection apparatus and wafer inspection method of the present invention, electrical connection to electrodes to be inspected of a wafer, which is an object of inspection, is achieved through the above probe member, so that positioning, and holding and fixing to the wafer can be conducted with ease even when the pitch of the electrodes to be inspected is small. In addition, the necessary electrical inspection can be stably performed over a long period of time even when the inspection is conducted repeatedly on wafers, on which integrated circuits having projected electrodes have been formed.

### BRIEF DESCRIPTION OF THE DRAWINGS

Fig. 1 is a plan view illustrating an exemplary anisotropically conductive connector according to the present invention.
Fig. 2 is a plan view illustrating, on an enlarged scale, a part of the anisotropically conductive connector shown in Fig. 1.
Fig. 3 is a plan view illustrating, on an enlarged scale, an elastic anisotropically conductive film in the anisotropically conductive connector shown in Fig. 1.
Fig. 4 is a cross-sectional view illustrating, on an enlarged scale, the elastic anisotropically conductive film in the anisotropically conductive connector shown in Fig. 1.
Fig. 5 is a cross-sectional view illustrating a state that a molding material has been applied to a mold for molding elastic anisotropically conductive films to form molding material layers.
Fig. 6 is a cross-sectional view illustrating, on an enlarged scale, a part of the mold for molding elastic anisotropically conductive film.
Fig. 7 is a cross-sectional view illustrating a state that a frame plate has been arranged through spacers between a top force and a bottom force in the mold shown in Fig. 5.
Fig. 8 is a cross-sectional view illustrating a state that molding material layers of the intended form have been formed between the top force and the bottom force in the mold.
Fig. 9 is a cross-sectional view illustrating, on an enlarged scale, the molding material layer shown in Fig. 8.
Fig. 10 is a cross-sectional view illustrating a state that a magnetic field having an intensity distribution has been applied to the molding material layer shown in Fig. 9 in a thickness-wise direction thereof.
Fig. 11 is a cross-sectional view illustrating the construction of an exemplary wafer inspection apparatus according to the present invention.
Fig. 12 is a cross-sectional view illustrating the construction of a principal part of a probe member in the wafer inspection apparatus shown in Fig. 11.
Fig. 13 is a cross-sectional view illustrating the construction of a wafer inspection apparatus according to another embodiment of the present invention.
Fig. 14 is a cross-sectional view illustrating the construction of a principal part of a probe member in the wafer inspection apparatus shown in Fig. 13.
Fig. 15 is a plan view illustrating, on an enlarged scale, an elastic anisotropically conductive film in an anisotropically conductive connector according to another embodiment of the present invention.
Fig. 16 is a cross-sectional view illustrating, on an enlarged scale, the elastic anisotropically conductive film in the anisotropically conductive connector according to said another embodiment of the present invention.
Fig. 17 is a plan view illustrating, on an enlarged scale, an elastic anisotropically conductive film in an anisotropically conductive connector according to a further embodiment of the present invention.
Fig. 18 is a cross-sectional view illustrating the construction of a wafer inspection apparatus according to a further embodiment of the present invention.
Fig. 19 is a cross-sectional view illustrating the construction of a principal part of a probe member in the wafer inspection apparatus shown in Fig. 18.
Fig. 20 is a cross-sectional view illustrating the construction of a wafer inspection apparatus for inspecting wafers having projected electrodes.
Fig. 21 is a cross-sectional view illustrating the construction of a principal part of a probe member in the wafer inspection apparatus shown in Fig. 20.
Fig. 22 is a plan view illustrating, on an enlarged scale, an elastic anisotropically conductive film in an anisotropically conductive connector according to a still further embodiment of the present invention.
Fig. 23 is a top view of a wafer for evaluation used in Examples.
Fig. 24 illustrates a position of a region of electrodes to be inspected in an integrated circuit formed on the wafer for evaluation shown in Fig. 23.
Fig. 25 illustrates the electrodes to be inspected in the integrated circuit formed on the wafer for evaluation shown in Fig. 23.
Fig. 26 is a top view of a frame plate produced in Example.
Fig. 27 illustrates, on an enlarged scale, a part of the frame plate shown in Fig. 26.
Fig. 28 illustrates, on an enlarged scale, a molding surface of a mold produced in Example.
Fig. 29 is a cross-sectional view illustrating, on an enlarged scale, a part of a mold for molding elastic anisotropically conductive film used in obtaining a comparative anisotropically conductive connector.
Fig. 30 illustrates, on an enlarged scale, a molding surface of the mold for molding elastic anisotropically conductive film used in obtaining the comparative anisotropically conductive connector.
Fig. 31 is a cross-sectional view illustrating a state that a frame plate has been arranged within a mold in a process for producing a conventional anisotropically conductive connector, and a molding material layer has been formed.

### [Description of Characters]

- 1: Probe member,
- 2: Anisotropically conductive connector,
- 3: Pressurizing plate,
- 4: Wafer mounting table,
- 5: Heater,
- 6: Wafer,
- 7: Electrodes to be inspected,
- 10: Frame plate,
- 11: Anisotropically conductive film-arranging holes,
- 15: Air circulating holes, 16 Positioning holes,
- 20: Elastic anisotropically conductive films,
- 20A: Molding material layers, 21 Functional parts,
- 22: Conductive parts for connection,
- 23: Insulating part,
- 24: Projected parts,
- 25: Parts to be supported,
- 26: Conductive parts for non-connection,
- 30: Circuit board for inspection,
- 31: Inspection electrodes,
- 41: Insulating sheet,
- 40: Sheet-like connector,
- 42: Electrode structures,
- 43: Front-surface electrode parts,
- 44: Back-surface electrode parts,
- 45: Short circuit parts,
- 50: Chamber,
- 51: Evacuation pipe,
- 55: O-rings,
- 60: Mold,
- 61: Top force,
- 62: Base plate,
- 63,: 63a Ferromagnetic substance layers,
- 64: Non-magnetic substance layers,
- 64a, 64b, 64c: Recessed parts,
- 65: Bottom force,
- 66: Base plate,
- 67, 67a: Ferromagnetic substance layers,
- 68: Non-magnetic substance layers,
- 68a, 68b, 68c: Recessed parts,
- 69a, 69b: Spacers,
- 81: Top force,
- 82: Base plate,
- 83: Ferromagnetic substance layers,
- 84: Non-magnetic substance layers,
- 84a: Recessed parts
- 85: Bottom force,
- 86: Base plate
- 87: Ferromagnetic substance layers,
- 88: Non-magnetic substance layers, 88a Recessed parts,
- 90: Frame plate,
- 91: Opening,
- 95: Molding material layer
- P: Conductive particles.

### BEST MODE FOR CARRYING OUT THE INVENTION

The embodiments of the present invention will hereinafter be described in details.

### [Anisotropically conductive connector]

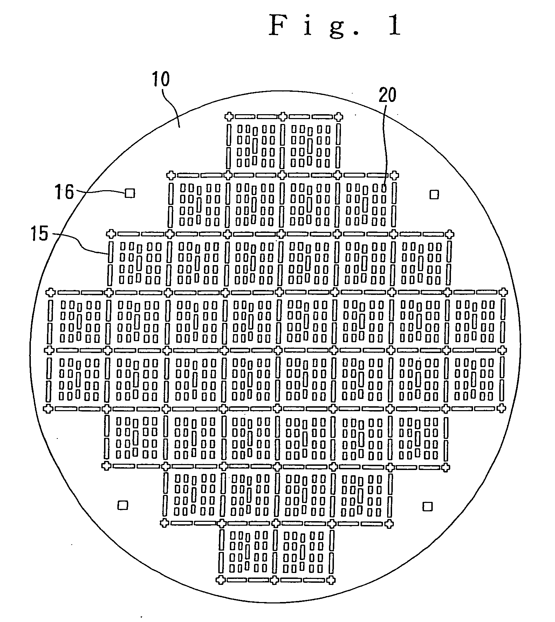

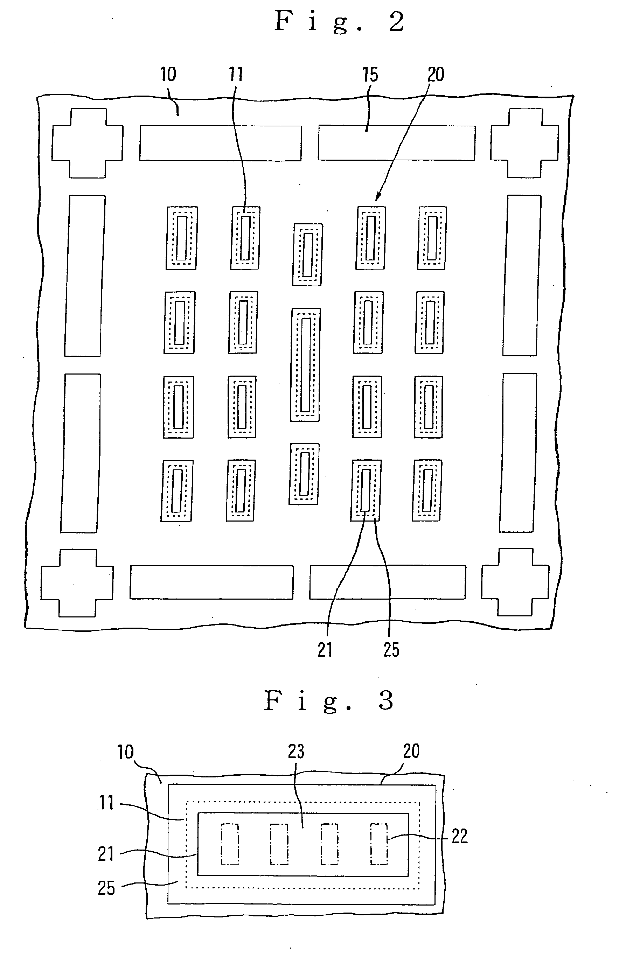

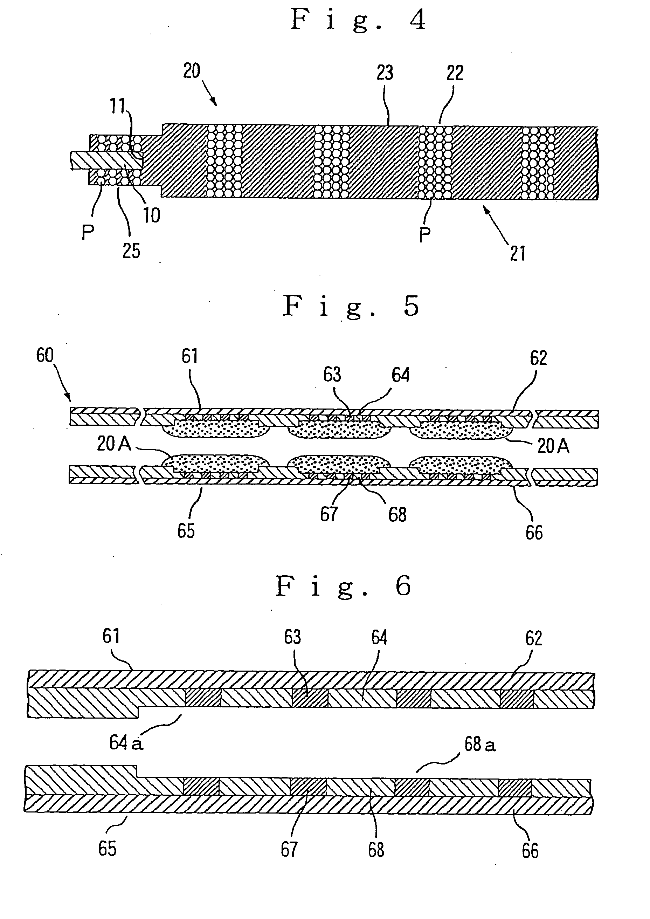

Fig. 1 is a plan view illustrating an exemplary anisotropically conductive connector according to the present invention, Fig. 2 is a plan view illustrating, on an enlarged scale, a part of the anisotropically conductive connector shown in Fig. 1, Fig. 3 is a plan view illustrating, on an enlarged scale, an elastic anisotropically conductive film in the anisotropically conductive connector shown in Fig. 1, and Fig. 4 is a cross-sectional view illustrating, on an enlarged scale, the elastic anisotropically conductive film in the anisotropically conductive connector shown in Fig. 1.

The anisotropically conductive connector shown in Fig. 1 is that used for conducting electrical inspection of each of, for example, a plurality of integrated circuits formed on a wafer in a state of the wafer and has a frame plate 10 in which a plurality of anisotropically conductive film-arranging holes 11 (indicated by broken lines) each extending through in a thickness-wise direction of the frame plate have been formed as illustrated in Fig. 2. The anisotropically conductive film-arranging holes 11 in this frame plate 10 are formed in accordance with a pattern of electrode regions, in which electrodes to be inspected have been formed in the integrated circuits formed on the wafer that is an object of inspection. Elastic anisotropically conductive films 20 having conductivity in the thickness-wise direction are arranged in the respective anisotropically conductive film-arranging holes 11 in the frame plate 10 in a state supported by the peripheral part about the anisotropically conductive film-arranging hole 11 of the frame plate 10 and in a state independent of adjacent elastic anisotropically conductive films 20 to each other. In the frame plate 10 of this embodiment, are formed air circulating holes 15 for passing air between the anisotropically conductive connector and a member adjacent thereto when a pressurizing means of a pressure reducing system is used in a wafer inspection apparatus, which will be described subsequently. In addition, positioning holes 16 for positioning between the wafer, which is the object of inspection, and a circuit board for inspection are formed.

Each of the elastic anisotropically conductive films 20 is formed by an elastic polymeric substance and, as illustrated in Fig. 3, has a functional part 21 composed of a plurality of conductive parts 22 for connection each extending in the thickness-wise direction (direction perpendicular to the paper in Fig. 3) of the film and an insulating part 23 formed around the respective conductive parts 22 for connection and mutually insulating these conductive parts 22 for connection. The functional part 21 is arranged so as to be located within the anisotropically conductive film-arranging hole 11 in the frame plate 10. The conductive parts 22 for connection in the functional part 21 are arranged in accordance with a pattern corresponding to a pattern of the electrodes to be inspected in the integrated circuit formed on the wafer, which is the object of inspection, and electrically connected to the electrodes to be inspected in the inspection of the wafer.

At a peripheral edge of the functional part 21, a part 25 to be supported, which is fixed to and supported by the periphery about the anisotropically conductive film-arranging hole 11 in the frame plate 10, is formed integrally and continuously with the functional part 21. More specifically, the part 25 to be supported in this embodiment is shaped in a forked form and fixed and supported in a closely contacted state so as to grasp the periphery about the anisotropically conductive film-arranging hole 11 in the frame plate 10.

In the conductive parts 22 for connection in the functional part 21 of the elastic anisotropically conductive film 20, conductive particles P exhibiting magnetism are contained at a high density in a state oriented so as to align in the thickness-wise direction as illustrated in Fig. 4. On the other hand, the insulating part 23 does not contain the conductive particles P at all or scarcely contain them. In this embodiment, the part 25 to be supported in the elastic anisotropically conductive film 20 contains the conductive particles P.

In the anisotropically conductive connector according to the present invention, assuming that a thickness of the conductive parts 22 for connection in the functional part 21 of the elastic anisotropically conductive film 20 is T1 and a thickness of the insulating part 23 in the functional part 21 is T2, a ratio (T2/T1) of the thickness of the insulating part 23 to the thickness of the conductive parts 22 for connection is at least 0.9, preferably 0.92 to 1.2. In this embodiment, both surfaces of the functional part 21 of the elastic anisotropically conductive film 20 are formed in a flat surface, and so the ratio (T2/T1) of the thickness of the insulating part 23 to the thickness of the conductive parts 22 for connection is 1. It is particularly preferred that the ratio (T2/T1) be 1 as described above, since yield in the production of the anisotropically conductive connector is improved, rise in the electric resistance of the conductive parts for connection due to deformation of the conductive parts for connection is inhibited even when the electrodes to be inspected have a projected form, and durability in repeated use is more improved.

If this ratio (T2/T1) is too low, conductive particles in a molding material layer are hard to be gathered to portions to become the conductive parts 22 for connection when a magnetic field having an intensity distribution is applied to the molding material layer in the formation of the anisotropically conductive film 20, so that an electric resistance of the resulting conductive parts 22 for connection becomes high, or an electric resistance between adjoining conductive parts 22 for connection becomes low in some cases.

In the anisotropically conductive connector in this embodiment, the functional part 21 in each of the elastic anisotropically conductive films 20 has a thickness greater than the thickness of the part 25 to be supported and is formed in such a manner that both surfaces of each functional part 21 protrudes from the part 25 to be supported.

In such an anisotropically conductive connector, assuming that a sum total of areas of one surfaces of the functional parts of all the elastic anisotropically conductive films is S1, and an area of a surface of the wafer, which is the object of inspection, on a side that the electrodes to be inspected have been formed, is S2, a ratio S1/S2 is preferably 0.001 to 0.3, more preferably 0.002 to 0.2.

If the value of this ratio S1/S2 is too low, there is a possibility that when such an anisotropically conductive connector is released from a pressurized state, each of the elastic anisotropically conductive films 20 may remain in a state compressed and become hard to restore to the original form either by the tackiness of the functional part 21 of each of the elastic anisotropically conductive films 20 by the weight of the circuit board for inspection or by tackiness of the elastic anisotropically conductive film 20 itself, whereby the durability in repeated use of the elastic anisotropically conductive films 20 may be markedly lowered in some cases. If the value of this ratio S1/S2 is too high on the other hand, such an anisotropically conductive connector must be pressurized under a considerably heavy load for achieving electrical connection to a wafer that is an object of inspection. Therefore, it is necessary to install a large-sized pressurizing mechanism in a wafer inspection apparatus. As a result, a problem that the wafer inspection apparatus itself becomes large-sized, and the production cost of the wafer inspection apparatus is increased arises. Since the anisotropically conductive connector is pressurized under a considerably heavy load, a problem that the anisotropically conductive connector, the circuit board for inspection and the wafer, which is the object of inspection, tend to be damaged also arises.

The thickness of the frame plate 10 varies according to the material thereof, but is preferably 20 to 600 µm, more preferably 40 to 400 µm.

If this thickness is less than 20 µm, the strength required upon use of the resulting anisotropically conductive connector is not achieved, and the durability thereof is liable to be lowered. In addition, such stiffness as the form of the frame plate is retained is not achieved, and the handling property of the anisotropically conductive connector becomes low. If the thickness exceeds 600 µm on the other hand, the elastic anisotropically conductive films 20 formed in the anisotropically conductive film-arranging holes 11 become too great in thickness, and it may be difficult in some cases to achieve good conductivity in the conductive parts 22 for connection and insulating property between adjoining conductive parts 22 for connection.

The form and size in a plane direction of the anisotropically conductive film-arranging holes 11 in the frame plate 10 are designed according to the size, pitch and pattern of electrodes to be inspected in a wafer that is an object of inspection.

No particular limitation is imposed on a material for forming the frame plate 10 so far as it has such stiffness as the resulting frame plate 10 is hard to be deformed, and the form thereof is stably retained. For example, various kinds of materials such as metallic materials, ceramic materials and resin materials may be used. When the frame plate 10 is formed by, for example, a metallic material, an insulating film may be formed on the surface of the frame plate 10.

Specific examples of the metallic material for forming the frame plate 10 include metals such as iron, copper, nickel, chromium, cobalt, magnesium, manganese, molybdenum, indium, lead, palladium, titanium, tungsten, aluminum, gold, platinum and silver, and alloys or alloy steels composed of a combination of at least two of these metals.

Specific examples of the resin material forming the frame plate 10 include liquid crystal polymers and polyimide resins.

The frame plate 10 may preferably exhibit magnetism at least at the peripheral portion about each of the anisotropically conductive film-arranging holes 11, i.e., a portion supporting the elastic anisotropically conductive film 20 in that the conductive particles P can be caused to be contained with ease in the part 25 to be supported in the elastic anisotropically conductive film 20 by a process which will be described subsequently. Specifically, this portion may preferably have a saturation magnetization of at least 0.1 Wb/m². In particular, the whole frame plate 10 may preferably be formed by a magnetic substance in that the frame plate 10 is easy to be produced.

Specific examples of the magnetic substance forming such a frame plate 10 include iron, nickel, cobalt, alloys of these magnetic metals, and alloys or alloy steels of these magnetic metals with any other metal.

When the resulting anisotropically conductive connector is used in the WLBI test, it is preferable to use a material having a coefficient of linear thermal expansion of at most 3 x 10⁻⁵/K, more preferably -1 x 10⁻⁷ to 1 x 10⁻⁵/K, particularly preferably 1 x 10⁻⁶ to 8 x 10⁻⁶/K as a material for forming the frame plate 10.

Specific examples of such a material include invar alloys such as invar, Elinvar alloys such as Elinvar, and alloys or alloy steels of magnetic metals, such as superinvar, covar and 42 alloy.

The overall thickness of the functional part 21 of the elastic anisotropically conductive film 20 is preferably 40 to 3,000 µm, more preferably 50 to 2,500 µm, particularly preferably 70 to 2,000 µm. When this thickness is 40 µm or greater, elastic anisotropically conductive films 20 having sufficient strength are provided with certainty. When this thickness is 3,000 µm or smaller on the other hand, conductive parts 22 for connection having necessary conductive properties are provided with certainty.

The thickness (thickness of one of the forked portions in the illustrated embodiment) of the part 25 to be supported is preferably 5 to 600 µm, more preferably 10 to 500 µm.

It is not essential for the part 25 to be supported to be form in the forked form so as to be fixed to both surfaces of the frame plate 10, and it may be fixed to only one surface of the frame plate 10.

As the elastic polymeric substance forming the elastic anisotropically conductive films 20, a heat-resistant polymeric substance having a crosslinked structure is preferred. Various materials may be used as curable polymeric substance-forming materials usable for obtaining such a crosslinked polymeric substance. However, liquid silicone rubber is preferred.

The liquid silicone rubber may be any of addition type and condensation type. However, the addition type liquid silicone rubber is preferred. This addition type liquid silicone rubber is that curable by a reaction of a vinyl group with a Si-H bond and includes a one-pack type (one-component type) composed of polysiloxane having both vinyl group and Si-H bond and a two-pack type (two-components type) composed of polysiloxane having a vinyl group and polysiloxane having an Si-H bond. In the present invention, addition type liquid silicone rubber of the two-pack type is preferably used.

As the addition type liquid silicone rubber, is used that having a viscosity of preferably 100 to 1,250 Pa·s, more preferably 150 to 800 Pa·s, particularly preferably 250 to 500 Pa·s at 23°C. If this viscosity is lower than 100 Pa·s, precipitation of the conductive particles in such addition type liquid silicone rubber is easy to occur in a molding material for obtaining the elastic anisotropically conductive films 20, which will be described subsequently, so that good storage stability is not obtained. In addition, the conductive particles are not oriented so as to align in the thickness-wise direction when a parallel magnetic field is applied to the molding material layer, so that it may be difficult in some cases to form chains of the conductive particles in an even state. If this viscosity exceeds 1,250 Pa·s on the other hand, the viscosity of the resulting molding material becomes too high, so that it may be difficult in some cases to form the molding material layer in the mold. In addition, the conductive particles are not sufficiently moved even when a parallel magnetic field is applied to the molding material layer. Therefore, it may be difficult in some cases to orient the conductive particles so as to align in the thickness-wise direction.

The viscosity of such addition type liquid silicone rubber can be measured by means of a Brookfield type viscometer.

When the elastic anisotropically conductive films 20 are formed by a cured product (hereinafter referred to as "cured silicon rubber") of the liquid silicone rubber, the cured silicone rubber preferably has a compression set of at most 10%, more preferably at most 8%, still more preferably at most 6% at 150°C. If the compression set exceeds 10%, chains of the conductive particles P in the conductive part 22 for connection are disordered when the resulting anisotropically conductive connector is used repeatedly under a high-temperature environment. As a result, it is difficult to retain the necessary conductivity.

In the present invention, the compression set of the cured silicone rubber can be measured by a method in accordance with JIS K 6249.

The cured silicone rubber forming the elastic anisotropically conductive films 20 preferably has a durometer A hardness of 10 to 60, more preferably 15 to 60, particularly preferably 20 to 60 at 23°C. If the durometer A hardness is lower than 10, the insulating part 23 mutually insulating the conductive parts 22 for connection is easily over-distorted when pressurized, and so it may be difficult in some cases to retain the necessary insulating property between the conductive parts 22 for connection. If the durometer A hardness exceeds 60 on the other hand, pressurizing force by a considerably heavy load is required for giving proper distortion to the conductive parts 22 for connection, so that, for example, a wafer, which is an object of inspection, tends to cause great deformation or breakage.

In the present invention, the durometer A hardness of the cured silicone rubber can be measured by a method in accordance with JIS K 6249.

Further, the cured silicone rubber for forming the elastic anisotropically conductive films 20 preferably has tear strength of at least 8 kN/m, more preferably at least 10 kN/m, still more preferably at least 15 kN/m, particularly preferably at least 20 kN/m at 23°C. If the tear strength is less than 8 kN/m, the resulting elastic anisotropically conductive films 20 tend to deteriorate durability when they are distorted in excess.

In the present invention, the tear strength of the cured silicone rubber can be measured by a method in accordance with JIS K 6249.

As the addition type liquid silicone rubber having such properties, may be used that marketed as liquid silicone rubber "KE2000" series, "KE1950" series or "KE1990" series from Shin-Etsu Chemical Co., Ltd.

In the present invention, a proper curing catalyst may be used for curing the addition type liquid silicone rubber. As such a curing catalyst, may be used a platinum-containing catalyst. Specific examples thereof include publicly known catalysts such as platinic chloride and salts thereof, platinum-unsaturated group-containing siloxane complexes, vinylsiloxane-platinum complexes, platinum-1,3-divinyltetramethyldisiloxane complexes, complexes of triorganophosphine or phosphite with platinum, acetyl acetate-platinum chelates, and cyclic diene-platinum complexes.

The amount of the curing catalyst used is suitably selected in view of the kind of the curing catalyst and other curing treatment conditions. However, it is generally 3 to 15 parts by weight per 100 parts by weight of the addition type liquid silicone rubber.

In order to improve the thixotropic property of the addition type liquid silicone rubber, adjust the viscosity, improve the dispersion stability of the conductive particles, provide a base material having high strength or the like, a general inorganic filler such as silica powder, colloidal silica, aerogel silica or alumina may be contained in the addition type liquid silicone rubber as needed.

No particular limitation is imposed on the amount of such an inorganic filler used. However, the use in a too large amount is not preferred because the orientation of the conductive particles by a magnetic field cannot be sufficiently achieved.

The number average particle diameter of the conductive particles P is preferably 3 to 30 µm, more preferably 6 to 15 µm.

Assuming that the number average particle diameter of the conductive particles P is Dn, and the weight average particle diameter thereof is Dw, conductive particles, whose ratio Dw/Dn (hereinafter referred to as "ratio Dw/Dn" merely) of the weight average particle diameter to the number average particle diameter is at most 5, are preferably used as the conductive particles P. Those having a ratio Dw/Dn of at most 3 are more preferably used. Necessary insulating property between adjoining conductive parts 22 for connection can be attained with more certainty by using such conductive particles.

In the present invention, the average particle diameter of the particles means a value measured by a laser diffraction scattering method.

Further, the conductive particles P preferably have a coefficient of variation of particle diameter of at most 50%, more preferably at most 35.

In the present invention, the coefficient of variation of particle diameter is a value determined in accordance with an expression: (σ/Dn) x 100, wherein σ is a standard deviation value of the particle diameter.

If the coefficient of variation of particle diameter of the conductive particles P exceeds 50%, it is difficult to attain the necessary insulating property between adjoining conductive parts 22 for connection with certainty.

No particular limitation is imposed on the shape of the conductive particles P. However, they are preferably in the shape of a sphere or star, or secondary particles obtained by aggregating these particles from the viewpoint of permitting easy dispersion of these particles in the polymeric substance-forming material.

Particles obtained by coating the surfaces of core particles (hereinafter also referred to as "magnetic core particles") exhibiting magnetism with a high-conductive metal are preferably used as the conductive particles P.

The term "high-conductive metal" as used herein means a metal having an electric conductivity of at least 5 x 10⁶ Ω⁻¹m⁻¹ at 0°C .

As a material for forming the magnetic core particles, may be used iron, nickel, cobalt, a material obtained by coating such a metal to copper or a resin, or the like. Those having a saturation magnetization of at least 0.1 Wb/m² may be preferably used. The saturation magnetization thereof is more preferably at least 0.3 Wb/m², particularly preferably 0.5 Wb/m². Specific examples of the material include iron, nickel, cobalt or alloys thereof. Among these, nickel is preferred.

When this saturation magnetization is at least 0.1 Wb/m², the conductive particles P can be easily moved in the molding material layers for forming the elastic anisotropically conductive films 20 by a process, which will be described subsequently, whereby the conductive particles P can be surely moved to portions to become conductive parts for connection in the molding material layer to form chains of the conductive particles P.

As the high-conductive metal for coating the magnetic core particles, may be used gold, silver, rhodium, platinum, chromium or the like. Among these, gold is preferably used in that it is chemically stable and has a high electric conductivity.

In order to obtain conductive parts 22 for connection having high conductivity, particles, in which a proportion [(mass of high-conductive metal/mass of core particles) x 100] of the high-conductive metal to the core particles is at least 15% by mass, are preferably used, and the proportion of the high-conductive metal to the core particles is more preferably 25 to 35% by mass.

The water content in the conductive particles P is preferably at most 5%, more preferably at most 3%, still more preferably at most 2%, particularly preferably at most 1%. The use of the conductive particles P satisfying such conditions can prevent or inhibit the occurrence of bubbles in the molding material layer upon a curing treatment of the molding material layer in the production process, which will be described subsequently.

Such conductive particles P may be obtained in accordance with, for example, the following process.

Particles are first formed from a ferromagnetic substance in accordance with a method known per se in the art, or commercially available particles of a ferromagnetic substance are provided. The particles are subjected to a classification treatment as needed.

The classification treatment of the particles can be conducted by means of, for example, a classifier such as an air classifier or sonic classifier.

Specific conditions for the classification treatment are suitably preset according to the intended number average particle diameter of the magnetic core particles, the kind of the classifier, and the like.

Surfaces of the magnetic core particles are then treated with an acid and further washed with, for example, purified water, thereby removing impurities such as dirt, foreign matter and oxidized films present on the surfaces of the magnetic core particles. Thereafter, the surfaces of the magnetic core particles are coated with a high-conductive metal, thereby obtaining conductive particles exhibiting magnetism.

As examples of the acid used for treating the surfaces of the magnetic core particles, may be mentioned hydrochloric acid.

As a method for coating the surfaces of the magnetic core particles with the high-conductive metal, may be used electroless plating, displacement plating or the like. However, the method is not limited to these methods.

A process for producing the conductive particles by the electroless plating or displacement plating will be described. The magnetic core particles subjected to the acid treatment and washing treatment are first added to a plating solution to prepare a slurry, and electroless plating or displacement plating on the magnetic core particles is conducted while stirring the slurry. The particles in the slurry are then separated from the plating solution. Thereafter, the particles separated are subjected to a washing treatment with, for example, purified water, thereby obtaining conductive particles with the surfaces of the magnetic core particles coated with the high-conductive metal.

Alternatively, primer plating may be conducted on the surfaces of the magnetic core particles to form a primer plating layer, and a plating layer composed of the high-conductive metal may be then formed on the surface of the primer plating layer. No particular limitation is imposed on the process for forming the primer plating layer and the plating layer formed thereon. However, it is preferable to form the primer plating layer on the surfaces of the magnetic core particles by the electroless plating and then form the plating layer composed of the high-conductive metal on the surface of the primer plating layer by the displacement plating.

No particular limitation is imposed on the plating solution used in the electroless plating or displacement plating, and various kinds of commercially available plating solutions may be used.

The conductive particles obtained in such a manner are subjected to a classification treatment for the purpose of providing particles having the above-described particle diameter and particle diameter distribution.

As a classifier for conducting the classification treatment of the conductive particles, may be used that exemplified as the classifier used in the above-described classification treatment of the magnetic core particles. However, at least the air classifier is preferably used. The conductive particles are subjected to a classification treatment by the air classifier, whereby conductive particles having the above-described particle diameter and particle diameter distribution can be surely obtained.

The conductive particles P may be treated with a coupling agent such as a silane coupling agent as needed. By treating the surfaces of the conductive particles P with the coupling agent, the adhesion property of the conductive particles P to the elastic polymeric substance is improved. As a result, durability in repeated use of the resulting elastic anisotropically conductive films 20 become high.

The amount of the coupling agent used is suitably selected within limits not affecting the conductivity of the conductive particles P. However, it is preferably such an amount that a coating rate (proportion of an area coated with the coupling agent to the surface area of the conductive particles) of the coupling agent on the surfaces of the conductive particles P amounts to at least 5%, more preferably 7 to 100%, further preferably 10 to 100%, particularly preferably 20 to 100%.

The proportion of the conductive particles P contained in the conductive parts 22 for connection in the functional part 21 is preferably 10 to 60%, more preferably 15 to 50% in terms of volume fraction. If this proportion is lower than 10%, it may be impossible in some cases to obtain conductive parts 22 for connection having a sufficiently low electric resistance value. If this proportion exceeds 60% on the other hand, the resulting conductive parts 22 for connection are liable to be brittle, so that elasticity required of the conductive parts 22 for connection may not be achieved in some cases.

The proportion of the conductive particles P contained in the parts 25 to be supported varies according to the content of the conductive particles in the molding material for forming the elastic anisotropically conductive films 20. However, it is preferably equivalent to or more than the proportion of the conductive particles contained in the molding material in that the conductive particles P are surely prevented from being contained in excess in the conductive parts 22 for connection located most outside among the conductive parts 22 for connection in the elastic anisotropically conductive film 20. It is also preferable that the proportion be at most 30% in terms of volume fraction in that parts 25 to be supported having sufficient strength are provided.

The anisotropically conductive connector described above may be produced, for example, in the following manner.

A frame plate 10 composed of a magnetic metal, in which anisotropically conductive film-arranging holes 11 have been formed corresponding to a pattern of electrode regions, in which electrodes to be inspected have been formed, of integrated circuits in a wafer, which is an object of inspection, is first produced. As a method for forming the anisotropically conductive film-arranging holes 11 in the frame plate 10, may be used, for example, an etching method or the like.

A molding material for elastic anisotropically conductive films with conductive particles exhibiting magnetism dispersed in addition type liquid silicone rubber is then prepared. As illustrated in Fig. 5, a mold 60 for molding elastic anisotropically conductive films is provided, and the molding material for elastic anisotropically conductive films is applied to the molding surfaces of a top force 61 and a bottom force 65 in the mold 60 in accordance with a necessary pattern, namely, an arrangement pattern of elastic anisotropically conductive films to be formed, thereby forming molding material layers 20A.

The mold 60 will be described specifically. This mold 60 is so constructed that the top force 61 and the bottom force 65 making a pair therewith are arranged so as to be opposed to each other.

In the top force 61, ferromagnetic substance layers 63 are formed in accordance with a pattern antipodal to an arrangement pattern of the conductive parts 22 for connection in each of the elastic anisotropically conductive films 20 to be molded on the lower surface of a base plate 62, and non-magnetic substance layers 64 are formed at other portions than the ferromagnetic substance layers 63 as illustrated, on an enlarged scale, in Fig. 6. A molding surface is formed by these ferromagnetic substance layers 63 and non-magnetic substance layers 64.

In the bottom force 65 on the other hand, ferromagnetic substance layers 67 are formed in accordance with the same pattern as the arrangement pattern of the conductive parts 22 for connection in the elastic anisotropically conductive films 20 to be molded on the upper surface of a base plate 66, and non-magnetic substance layers 68 are formed at other portions than the ferromagnetic substance layers 67. A molding surface is formed by these ferromagnetic substance layers 67 and non-magnetic substance layers 68.

Recessed parts 64a and 68a are formed in the molding surfaces of the top force 61 and the bottom force 65, respectively, for forming functional parts 21 having a thickness greater than the thickness of the parts 25 to be supported.

The respective base plates 62 and 66 in the top force 61 and bottom force 65 are preferably formed by a ferromagnetic substance. Specific examples of such a ferromagnetic substance include ferromagnetic metals such as iron, iron-nickel alloys, iron-cobalt alloys, nickel and cobalt. The base plates 62, 66 preferably have a thickness of 0.1 to 50 mm, and surfaces thereof are preferably smooth, subjected to a chemical degreasing treatment or mechanical polishing treatment.

As a material for forming the ferromagnetic substance layers 63, 67 in both top force 61 and bottom force 65, may be used a ferromagnetic metal such as iron, iron-nickel alloy, iron-cobalt alloy, nickel or cobalt. The ferromagnetic substance layers 63, 67 preferably have a thickness of at least 10 µm. When this thickness is at least 10 µm, a magnetic field having a sufficient intensity distribution can be applied to the molding material layers 20A. As a result, the conductive particles can be gathered at a high density to portions to become conductive parts 22 for connection in the molding material layers 20A, and so conductive parts 22 for connection having good conductivity can be provided.

As a material for forming the non-magnetic substance layers 64, 68 in both top force 61 and bottom force 65, may be used a non-magnetic metal such as copper, a polymeric substance having heat resistance, or the like. However, a polymeric substance cured by magnetic waves may preferably be used in that the non-magnetic substance layers 64, 68 can be easily formed by a technique of photolithography. As a material thereof, may be used, for example, a photoresist such as an acrylic type dry film resist, epoxy type liquid resist or polyimide type liquid resist.

As a method for coating the molding surfaces of the top force 61 and bottom force 65 with the molding material, may preferably be used a screen printing method. According to such a method, the molding material can be easily applied according to the necessary pattern, and a proper amount of the molding material can be applied.

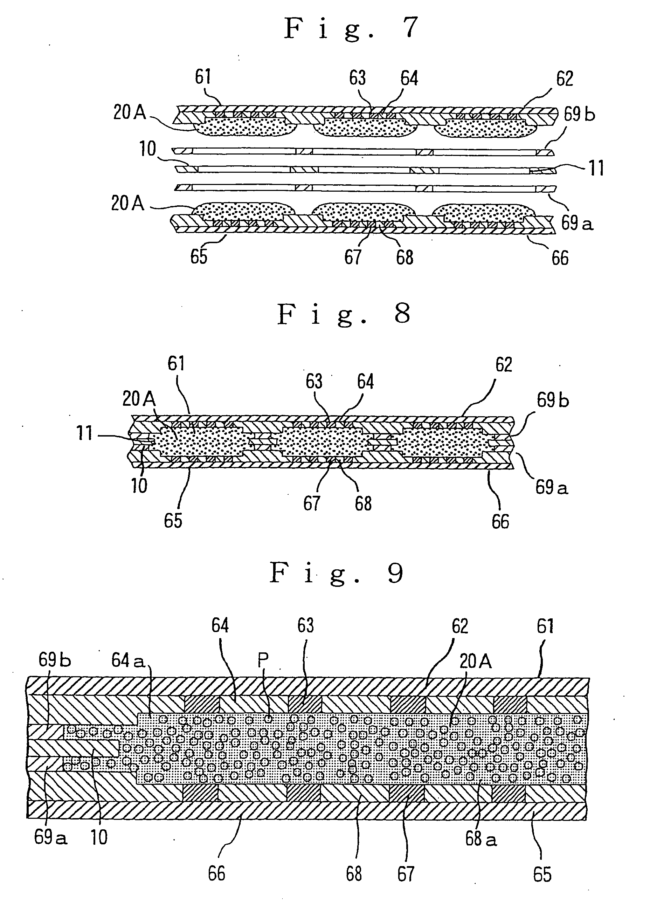

As illustrated in Fig. 7, the frame plate 10 is then arranged in alignment on the molding surface of the bottom force 65, on which the molding material layers 20A have been formed, through a spacer 69a, and on the frame plate 10, the top force 61, on which the molding material layers 20A have been formed, is arranged in alignment through a spacer 69b. These are superimposed on each other, whereby molding material layers 20A of the intended shape (shape of the elastic anisotropically conductive films 20 to be formed) are formed between the top force 61 and the bottom force 65 as illustrated in Fig. 8. In each of these molding material layers 20A, the conductive particles P are contained in a state dispersed throughout in the molding material layer 20A as illustrated in Fig. 9.

The spacers 69a and 69b are arranged between the frame plate 10, and the bottom force 65 and the top force 61, respectively as described above, whereby the elastic anisotropically conductive films of the intended shape can be formed, and adjoining elastic anisotropically conductive films are prevented from being connected to each other, so that a great number of anisotropically conductive films independent of one another can be formed with certainty.

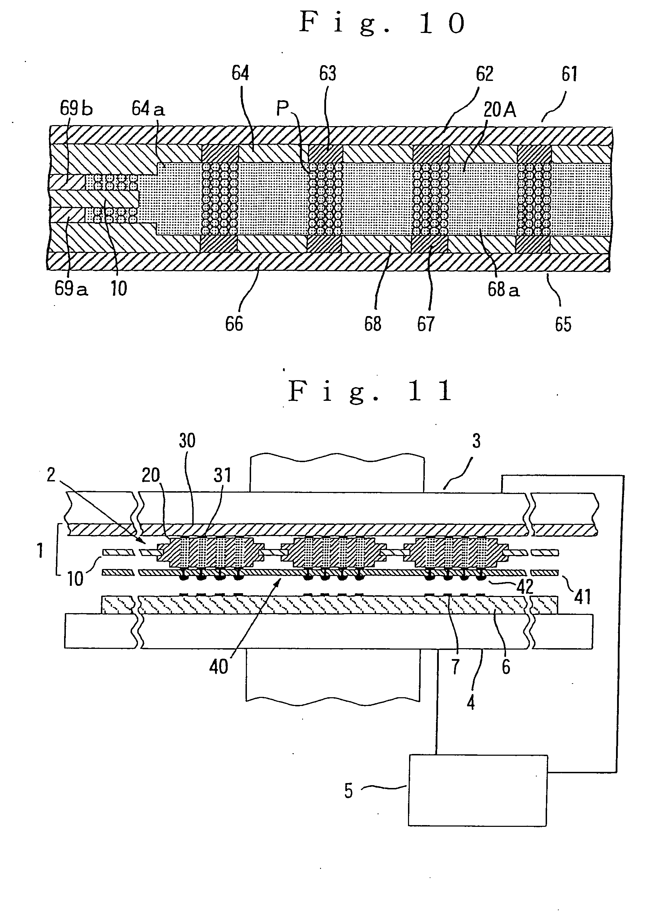

A pair of, for example, electromagnets are then arranged on the upper surface of the base plate 62 in the top force 61 and the lower surface of the base plate 66 in the bottom force 65, and the electromagnets are operated, whereby a magnetic field having higher intensity at portions between the ferromagnetic substance layers 63 of the top force 61 and their corresponding ferromagnetic substance layers 67 of the bottom force 65 than surrounding regions thereof is formed because the ferromagnetic substance layers 63, 67 of the top force 61 and bottom force 65 function as magnetic poles. As a result, in the molding material layers 20A, the conductive particles P dispersed in the molding material layers 20A are gathered to portions to become the conductive parts 22 for connection, which are located between the ferromagnetic substance layers 63 of the top force 61 and their corresponding ferromagnetic substance layers 67 of the bottom force 65, and oriented so as to align in the thickness-wise direction as illustrated in Fig. 10. In the above-described process, since the frame plate 10 is composed of the magnetic metal, a magnetic field having higher intensity at portions between each of the top force 61 and the bottom force 65, and the frame plate 10 than vicinities thereof is formed. As a result, the conductive particles P existing above and below the frame plate 10 in the molding material layers 20A are not gathered between the ferromagnetic substance layers 63 of the top force 61 and the ferromagnetic substance layers 67 of the bottom force 65, but remain retained above and below the frame plate 10.

In this state, the molding material layers 20A are subjected to a curing treatment, whereby the elastic anisotropically conductive films 20 each composed of a functional part 21, in which a plurality of conductive parts 22 for connection containing the conductive particles P in the elastic polymeric substance in a state oriented so as to align in the thickness-wise direction are arranged in a state mutually insulated by an insulating part 23 composed of the elastic polymeric substance, in which the conductive particles P are not present at all or scarcely present, and a part 25 to be supported, which is continuously and integrally formed at a periphery of the functional part 21 and in which the conductive particles P are contained in the elastic polymeric substance, are formed in a state that the part 25 to be supported has been fixed to the periphery of each anisotropically conductive film-arranging hole 11 of the frame plate 10, thus producing an anisotropically conductive connector.

In the above-described process, the intensity of the external magnetic field applied to the portions to become the conductive parts 22 for connection and the portions to become the parts 25 to be supported in the molding material layers 20A is preferably an intensity that it amounts to 0.1 to 2.5 T on the average.

The curing treatment of the molding material layers 20A is suitably selected according to the material used. However, the treatment is generally conducted by a heating treatment. When the curing treatment of the molding material layers 20A is conducted by heating, it is only necessary to provide a heater in an electromagnet. Specific heating temperature and heating time are suitably selected in view of the kinds of the polymeric substance-forming material for forming the molding material layers 20A, and the like, the time required for movement of the conductive particles P, and the like.

According to the above-described anisotropically conductive connector, since the part 25 to be supported is formed at the peripheral edge of the functional part 21 having the conductive parts 22 for connection in each of the elastic anisotropically conductive films 20, and this part 25 to be supported is fixed to the periphery about the anisotropically conductive film-arranging hole 11 in the frame plate 10, the anisotropically conductive connector is hard to be deformed and easy to handle, so that the positioning and the holding and fixing to a wafer, which is an object of inspection, can be easily conducted in an electrically connecting operation to the wafer.

In addition, since there is no difference in thickness between the conductive parts 22 for connection and the insulating part 23 in the functional part 21 of each of the elastic anisotropically conductive films 20, the mold used in the formation of the elastic anisotropically conductive films 20 has a flat molding surface, and so the movement of the conductive particles P is not inhibited when the magnetic field is applied to the molding material layers 20A, and the conductive particles P can be easily gathered to portions to become the conductive parts 22 for connection almost without remaining at a portion to become the insulating part in the molding material layers 20A. As a result, good conductivity is surely achieved as to all the conductive parts 22 for connection formed and sufficient insulating property is surely attained between adjoining conductive parts 22 for connection.

Further, since there is no difference in height level between the conductive parts 22 for connection and the insulating part 23 in the surface of the functional part 21 of each of the elastic anisotropically conductive films 20, the occurrence of permanent deformation of the conductive parts 22 for connection due to crush of the projected parts thereof is avoided even when a wafer, which is an object of inspection, has projected electrodes to be inspected, and so high durability in repeated use is attained.

One flat surface of the functional part 21 in the elastic anisotropically conductive film 20 is formed so as to project from the part 25 to be supported, and the ratio of the area of the one surfaces of the functional parts to the area of the front surface of the wafer, which is the object of inspection, falls within a specified range, whereby a load is applied concentratedly only to the functional parts when the anisotropically conductive connector is pressurized in a thickness-wise direction, so that good conductivity is surely achieved on the conductive parts 22 for connection even when pressurized under a small load.

Since the respective anisotropically conductive film-arranging holes 11 in the frame plate 10 are formed corresponding to the electrode regions, in which electrodes to be inspected have been formed, of integrated circuits in a wafer, which is an object of inspection, and the elastic anisotropically conductive film 20 arranged in each of the anisotropically conductive film-arranging holes 11 may be small in area, the individual elastic anisotropically conductive films 20 are easy to be formed. In addition, since the elastic anisotropically conductive film 20 small in area is little in the absolute quantity of thermal expansion in a plane direction of the elastic anisotropically conductive film 20 even when it is subjected to thermal hysteresis, the thermal expansion of the elastic anisotropically conductive film 20 in the plane direction is surely restrained by the frame plate 10 by using a material having a low coefficient of linear thermal expansion as that for forming the frame plate 10. Accordingly, a good electrically connected state can be stably retained even when the WLBI test is performed on a large-area wafer.

Further, the frame plate 10 composed of a ferromagnetic substance is used, whereby the conductive particles P existing in the portions to become parts 25 to be supported in the molding material layer 20A, i.e., the portions located above and below the peripheries about the anisotropically conductive film-arranging holes 11 in the frame plate 10 are not gathered to the portions to become conductive parts 22 for connection when the molding material layers 20A are subjected to the curing treatment in a state that the conductive particles P have been existed in the portions to become the parts 25 to be supported in the molding material layers 20A by applying, for example, a magnetic field to said portions in the formation of the elastic anisotropically conductive films 20. As a result, the conductive particles P are surely prevented from being contained in excess in the conductive parts 22 for connection located most outside among the conductive parts 22 for connection in the elastic anisotropically conductive film 20 thus obtained. Accordingly, there is no need to reduce the content of the conductive particles P in the molding material layers 20A, so that good conductivity is surely achieved as to all the conductive parts 22 for connection of the elastic anisotropically conductive film 20, and insulating property between adjoining conductive parts 22 for connection is surely attained.

Since the positioning holes 16 are formed in the frame plate 10, positioning to the wafer, which is the object of inspection, or the circuit board for inspection can be easily conducted.

Since the air circulating holes 15 are formed in the frame plate 10, air existing between the anisotropically conductive connector and the circuit board for inspection is discharged through the air circulating holes 15 in the frame plate 10 at the time the pressure within a chamber is reduced when that by the pressure reducing system is utilized as the means for pressing the probe member in a wafer inspection apparatus, which will be described subsequently, whereby the anisotropically conductive connector can be surely brought into close contact with the circuit board for inspection, so that the necessary electrical connection can be achieved with certainty.

### [Wafer inspection apparatus]

Fig. 11 is a cross-sectional view schematically illustrating the construction of an exemplary wafer inspection apparatus making use of the anisotropically conductive connector according to the present invention. This wafer inspection apparatus serves to perform electrical inspection of each of a plurality of integrated circuits formed on a wafer in a state of the wafer.

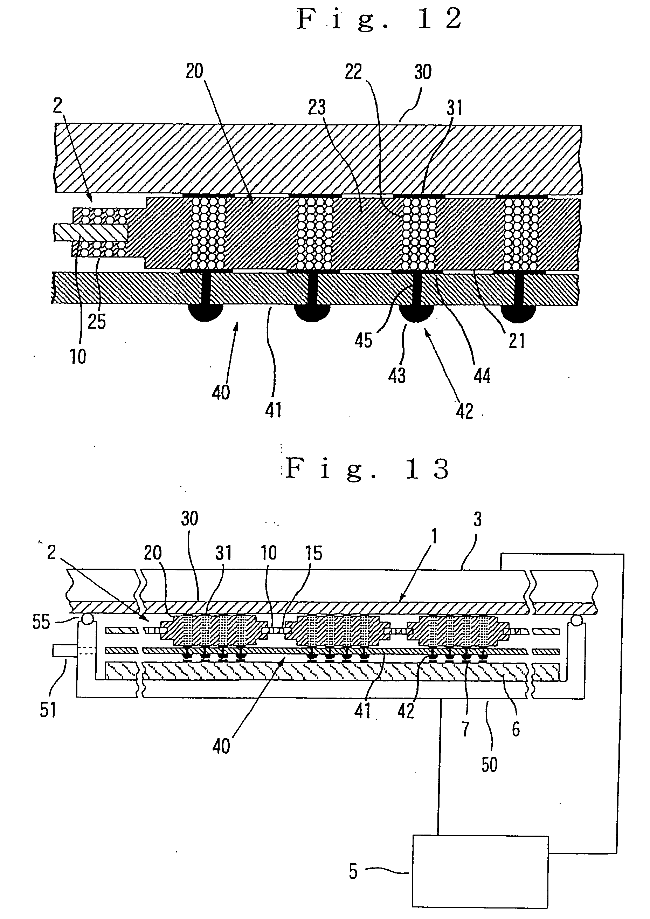

The wafer inspection apparatus shown in Fig. 11 has a probe member 1 for conducting electrical connection of each of electrodes 7 to be inspected of a wafer 6, which is an object of inspection, to a tester. As also illustrated on an enlarged scale in Fig. 12, the probe member 1 has a circuit board 30 for inspection, on the front surface (lower surface in Fig. 11) of which a plurality of inspection electrodes 31 have been formed in accordance with a pattern corresponding to a pattern of the electrodes 7 to be inspected of the wafer 6 that is the object of inspection. On the front surface of the circuit board 30 for inspection, is provided the anisotropically conductive connector 2 of the construction illustrated in Figs. 1 to 4 in such a manner that the conductive parts 22 for connection in the elastic anisotropically conductive films 20 of the connector are opposed to and brought into contact with the inspection electrodes 31 of the circuit board 30 for inspection, respectively. On the front surface (lower surface in the figure) of the anisotropically conductive connector 2, is provided a sheet-like connector 40, in which a plurality of electrode structures 42 have been arranged in an insulating sheet 41 in accordance with the pattern corresponding to the pattern of the electrodes 7 to be inspected of the wafer 6, which is the object of inspection, in such a manner that the electrode structures 42 are opposed to and brought into contact with the conductive parts 22 for connection in the elastic anisotropically conductive films 20 of the anisotropically conductive connector 2, respectively.

On the back surface (upper surface in the figure) of the circuit board 30 for inspection in the probe member 1, is provided a pressurizing plate 3 for pressurizing the probe member 1 downward. A wafer mounting table 4, on which the wafer 6 that is the object of inspection is mounted, is provided below the probe member 1. A heater 5 is connected to each of the pressurizing plate 3 and the wafer mounting table 4.

As a base material for making up the circuit board 30 for inspection, may be used any of conventionally known various base materials. Specific examples thereof include composite resin materials such as glass fiber-reinforced epoxy resins, glass fiber-reinforced phenol resins, glass fiber-reinforced polyimide resins and glass fiber-reinforced bismaleimidotriazine resins, and ceramic materials such as glass, silicon dioxide and alumina.

When a wafer inspection apparatus for conducting the WLBI test is constructed, a material having a coefficient of linear thermal expansion of at most 3 x 10⁻⁵/K, more preferably 1 x 10⁻⁷ to 1 x 10⁻⁵/K, particularly preferably 1 x 10⁻⁶ to 6 x 10⁻⁶/K is preferably used.

Specific examples of such a base material include Pyrex (trademark) glass, quartz glass, alumina, beryllia, silicon carbide, aluminum nitride and boron nitride.

The sheet-like connector 40 in the probe member 1 will be described specifically. This sheet-like connector 40 has a flexible insulating sheet 41, and in this insulating sheet 41, a plurality of electrode structures 42 extending in a thickness-wise direction of the insulating sheet 41 and composed of a metal are arranged in a state separated from each other in a plane direction of the insulating sheet 41 in accordance with the pattern corresponding to the pattern of the electrodes 7 to be inspected of the wafer 6 that is the object of inspection.

Each of the electrode structures 42 is formed by integrally connecting a projected front-surface electrode part 43 exposed to the front surface (lower surface in the figure) of the insulating sheet 41 and a plate-like back-surface electrode part 44 exposed to the back surface of the insulating sheet 41 to each other by a short circuit part 45 extending through in the thickness-wise direction of the insulating sheet 41.

No particular limitation is imposed on the insulating sheet 41 so far as it has insulating property and is flexible. For example, a resin sheet formed of a polyamide resin, liquid crystal polymer, polyester, fluororesin or the like, or a sheet obtained by impregnating a cloth woven by fibers with any of the above-described resins may be used.

No particular limitation is also imposed on the thickness of the insulating sheet 41 so far as such an insulating sheet 41 is flexible. However, it is preferably 10 to 50 µm, more preferably 10 to 25 µm.

As a metal for forming the electrode structures 42, may be used nickel, copper, gold, silver, palladium, iron or the like. The electrode structures 42 may be any of those formed of a simple metal as a whole, those formed of an alloy of at least two metals and those obtained by laminating at least two metals.

On the surfaces of the front-surface electrode part 43 and back-surface electrode part 44 in the electrode structure 42, a film of a chemically stable metal having high conductivity, such as gold, silver or palladium is preferably formed in that oxidation of the electrode parts is prevented, and electrode parts small in contact resistance are obtained.

The projected height of the front-surface electrode part 43 in the electrode structure 42 is preferably 15 to 50 µm, more preferably 15 to 30 µm in that stable electrical connection to the electrode 7 to be inspected of the wafer 6 can be achieved. The diameter of the front-surface electrode part 43 is preset according to the size and pitch of the electrodes to be inspected of the wafer 6 and is, for example, 30 to 80 µm, preferably 30 to 50 µm.

It is only necessary for the diameter of the back-surface electrode part 44 in the electrode structure 42 to be greater than the diameter of the short circuit part 45 and smaller than the arrangement pitch of the electrode structures 42, and the diameter is preferably great as much as possible, whereby stable electrical connection also to the conductive part 22 for connection in the elastic anisotropically conductive film 20 of the anisotropically conductive connector 2 can be achieved with certainty. The thickness of the back-surface electrode part 44 is preferably 20 to 50 µm, more preferably 35 to 50 µm in that the strength is sufficiently high, and excellent repetitive durability is achieved.

The diameter of the short circuit part 45 in the electrode structure 42 is preferably 30 to 80 µm, more preferably 30 to 50 µm in that sufficiently high strength is achieved.

The sheet-like connector 40 can be produced, for example, in the following manner.

Namely, a laminate material obtained by laminating a metal layer on an insulating sheet 41 is provided, and a plurality of through-holes extending through in the thickness-wise direction of the insulating sheet 41 are formed in the insulating sheet 41 of the laminate material in accordance with a pattern corresponding to a pattern of electrode structures 42 to be formed by laser machining, wet etch machining, dry etch machining or the like. This laminate material is then subjected to photolithography and a plating treatment, whereby short circuit parts 45 integrally connected to the metal layer are formed in the through-holes in the insulating sheet 41, and at the same time, projected front-surface electrode parts 43 integrally connected to the respective short circuit parts 45 are formed on a front surface of the insulating sheet 41. Thereafter, the metal layer of the laminate material is subjected to a photo-etching treatment to remove a part thereof, thereby forming back-surface electrode parts 44 to form the electrode structures 42, thus obtaining the sheet-like connector 40.

In such an electrical inspection apparatus, a wafer 6, which is an object of inspection, is mounted on the wafer mounting table 4, and the probe member 1 is then pressurized downward by the pressurizing plate 3, whereby the respective front-surface electrode parts 43 in the electrode structures 42 of the sheet-like connector 40 thereof are brought into contact with their corresponding electrodes 7 to be inspected of the wafer 6, and further the respective electrodes 7 to be inspected of the wafer 6 are pressurized by the front-surface electrodes parts 43. In this state, each of the conductive parts 22 for connection in the elastic anisotropically conductive films 20 of the anisotropically conductive connector 2 are respectively held and pressurized by the inspection electrodes 31 of the circuit board 30 for inspection and the front-surface electrode parts 43 of the electrode structures 42 of the sheet-like connector 40 and compressed in the thickness-wise direction, whereby conductive paths are formed in the respective conductive parts 22 for connection in the thickness-wise direction thereof. As a result, electrical connection between the electrodes 7 to be inspected of the wafer 6 and the inspection electrodes 31 of the circuit board 30 for inspection is achieved. Thereafter, the wafer 6 is heated to a predetermined temperature through the wafer mounting table 4 and the pressurizing plate 3 by the heater 5. In this state, necessary electrical inspection is performed as to the each of a plurality of integrated circuits in the wafer 6.

According to such a wafer inspection apparatus, electrical connection to the electrodes 7 to be inspected of the wafer 6, which is the object of inspection, is achieved through the probe member 1 having the above-described anisotropically conductive connector 2. Therefore, positioning, and holding and fixing to the wafer can be conducted with ease even when the pitch of the electrodes 7 to be inspected is small. In addition, high reliability on connection to the respective electrodes to be inspected is achieved because the conductive parts 22 for connection of the elastic anisotropically conductive films 20 in the anisotropically conductive connector 2 have good conductivity, and insulating property between adjoining conductive parts 22 for connection is sufficiently secured, and moreover the necessary electrical inspection can be stably performed over a long period of time even when the inspection is conducted repeatedly.

Since each of the elastic anisotropically conductive films 20 in the anisotropically conductive connector 2 is small in its own area, and the absolute quantity of thermal expansion in a plane direction of the elastic anisotropically conductive film 20 is little even when it is subjected to thermal hysteresis, the thermal expansion of the elastic anisotropically conductive film 20 in the plane direction is surely restrained by the frame plate by using a material having a low coefficient of linear thermal expansion as that for forming the frame plate 10. Accordingly, a good electrically connected state can be stably retained even when the WLBI test is performed on a large-area wafer.

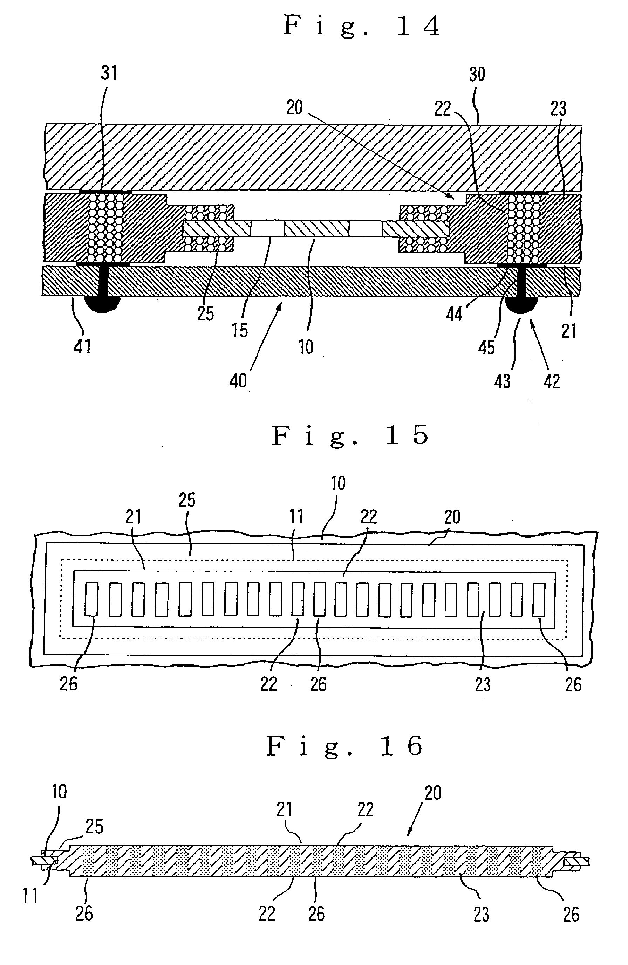

Fig. 13 is a cross-sectional view schematically illustrating the construction of another exemplary wafer inspection apparatus making use of the anisotropically conductive connector according to the present invention, and Fig. 14 is a cross-sectional view illustrating, on an enlarged scale, the construction of a probe member in the wafer inspection apparatus shown in Fig. 13.

This wafer inspection apparatus has a box-type chamber 50 opened at the top thereof, in which a wafer 6 that is an object of inspection is housed. An evacuation pipe 51 for evacuating air within the chamber 50 is provided in a sidewall of this chamber 50, and an evacuator (not illustrated) such as, for example, a vacuum pump, is connected to the evacuation pipe 51.

A probe member 1 of the same construction as the probe member 1 in the wafer inspection apparatus shown in Fig. 11 is arranged on the chamber 50 so as to air-tightly close the opening of the chamber 50. More specifically, an elastic O-ring 55 is arranged in close contact on an upper end surface of the sidewall in the chamber 50, and the probe member 1 is arranged in a state that the anisotropically conductive connector 2 and sheet-like connector 40 thereof have been housed in the chamber 50, and the periphery of the circuit board 30 for inspection thereof has been brought into close contact with the O-ring 55. Further, the circuit board 30 for inspection is held in a state pressurized downward by a pressurizing plate 3 provided on the back surface (upper surface in Fig. 13) thereof.

A heater 5 is connected to the chamber 50 and the pressurizing plate 3.

In such a wafer inspection apparatus, the evacuator (not illustrated) connected to the evacuation pipe 51 of the chamber 50 is driven, whereby the pressure within the chamber 50 is reduced to, for example, 1,000 Pa or lower. As a result, the probe member 1 is pressurized downward by the atmospheric pressure, whereby the O-ring 55 is elastically deformed, and so the probe member 1 is moved downward. As a result, the electrodes 7 to be inspected of the wafer 6 are respectively pressurized by their corresponding front-surface electrode parts 43 in the electrode structures 42 of the sheet-like connector 40. In this state, the conductive parts 22 for connection in the elastic anisotropically conductive films 20 of the anisotropically conductive connector 2 are respectively held and pressurized by the inspection electrodes 31 of the circuit board 30 for inspection and the front-surface electrode parts 43 in the electrode structures 42 of the sheet-like connector 40 and compressed in the thickness-wise direction, whereby conductive paths are formed in the respective conductive parts 22 for connection in the thickness-wise direction thereof. As a result, electrical connection between the electrodes 7 to be inspected of the wafer 6 and the inspection electrodes 31 of the circuit board 30 for inspection is achieved. Thereafter, the wafer 6 is heated to a predetermined temperature through the chamber 50 and the pressurizing plate 3 by the heater 5. In this state, necessary electrical inspection is performed on each of a plurality of integrated circuits in the wafer 6.

According to such a wafer inspection apparatus, the same effects as those in the wafer inspection apparatus shown in Fig. 11 are brought about. In addition, the whole inspection apparatus can be miniaturized because any large-sized pressurizing mechanism is not required, and moreover the whole wafer 6, which is the object of inspection, can be pressed by even force even when the wafer 6 has a large area of, for example, 8 inches or greater in diameter. In addition, since the air circulating holes 15 are formed in the frame plate 10 in the anisotropically conductive connector 2, air existing between the anisotropically conductive connector 2 and the circuit board 30 for inspection is discharged through the air circulating holes 15 of the frame plate 10 in the anisotropically conductive connector 2 when the pressure within the chamber 50 is reduced, whereby the anisotropically conductive connector 2 can be surely brought into close contact with the circuit board 30 for inspection, so that the necessary electrical connection can be achieved with certainty.

### [Other embodiments]

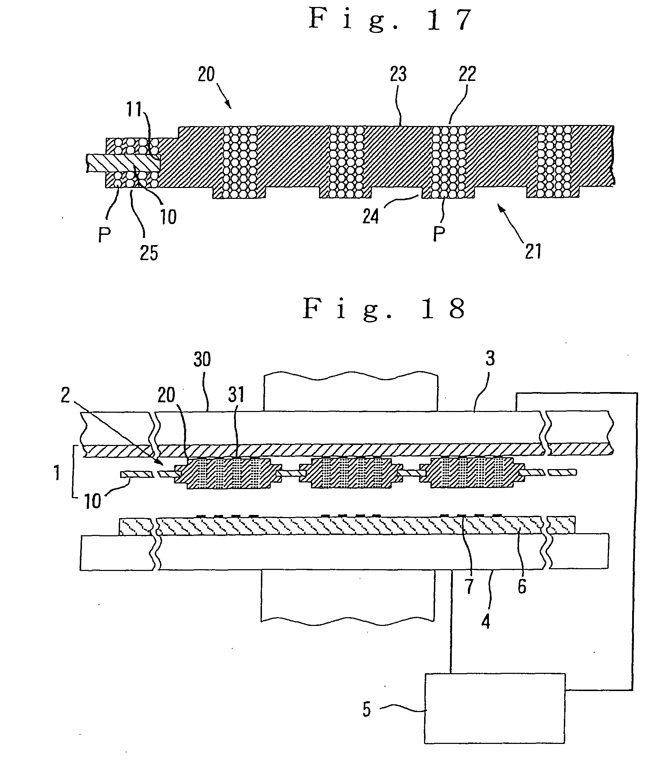

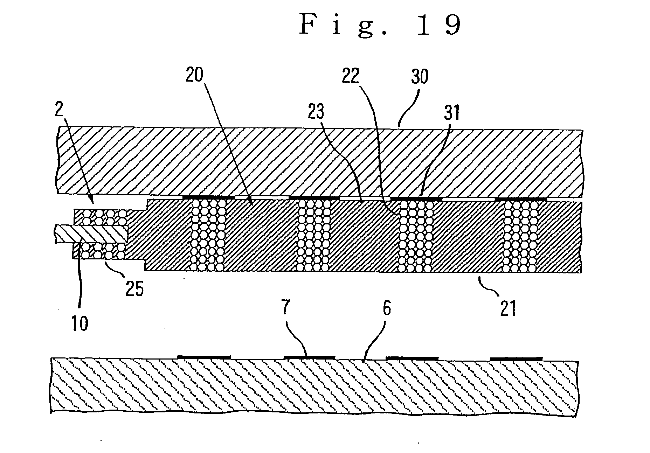

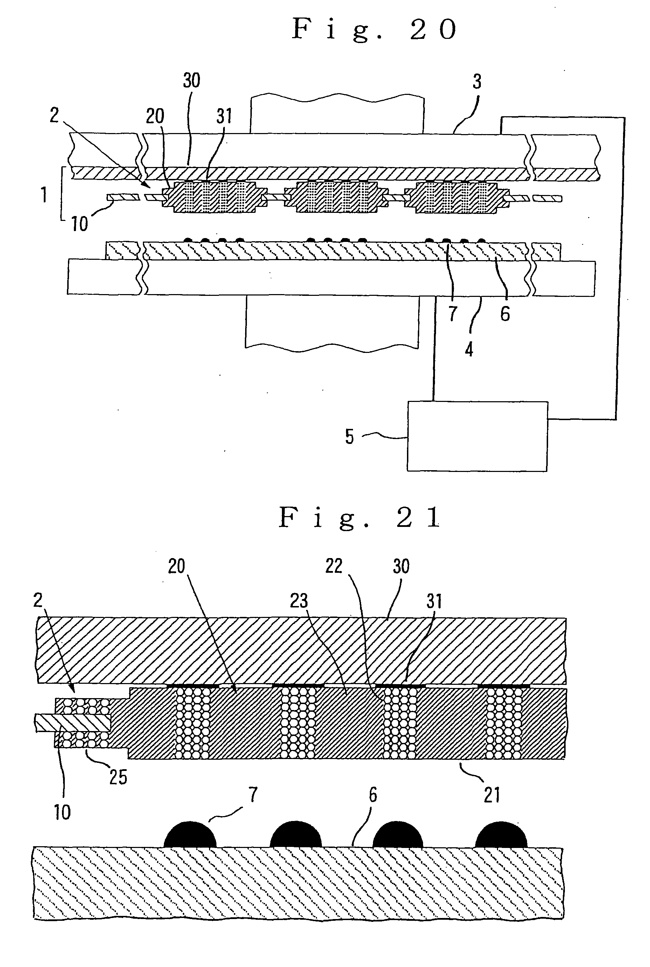

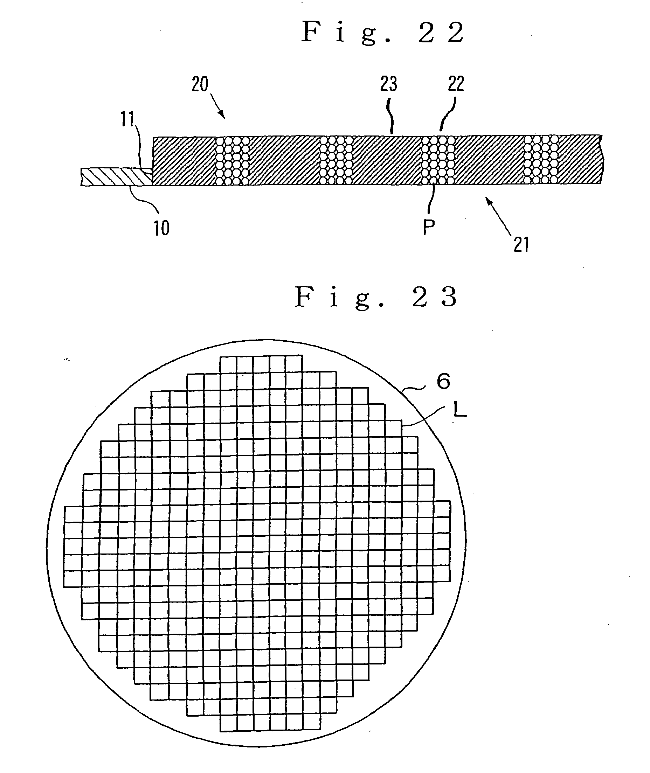

The present invention is not limited to the above-described embodiments, and the following various changes or modifications may be added thereto.
(1) In the anisotropically conductive connector according to the present invention, conductive parts for non-connection that are not electrically connected to any electrode to be inspected in a wafer may be formed in the elastic anisotropically conductive films 20 in addition to the conductive parts 22 for connection. An anisotropically conductive connector having anisotropically conductive films, in which the conductive parts for non-connection have been formed, will hereinafter be described.
   Fig. 15 is a plan view illustrating, on an enlarged scale, an elastic anisotropically conductive film in an anisotropically conductive connector according to another embodiment of the present invention, and Fig. 16 is a cross-sectional view illustrating, on an enlarged scale, the elastic anisotropically conductive film in the anisotropically conductive connector shown in Fig. 15. In the elastic anisotropically conductive film 20 of this anisotropically conductive connector, a plurality of conductive parts 22 for connection that are electrically connected to electrodes to be inspected in a wafer, which is an object of inspection, and extend in the thickness-wise direction (direction perpendicular to the paper in Fig. 15) are arranged so as to align in a line in accordance with a pattern corresponding to a pattern of the electrodes to be inspected. Each of these conductive parts 22 for connection contains conductive particles exhibiting magnetism at a high density in a state oriented so as to align in the thickness-wise direction and are mutually insulated by an insulating part 23, in which the conductive particles are not contained at all or scarcely contained.
   Two conductive parts 22 for connection adjoining each other and located at the center among these conductive parts 22 for connection are arranged at a clearance greater than a clearance between other conductive parts 22 for connection adjoining each other. A conductive part 26 for non-connection that is not electrically connected to any electrode to be inspected in the wafer, which is the object of inspection, and extend in the thickness-wise direction is formed between the two conductive parts 22 for connection adjoining each other and located at the center. Further, conductive parts 26 for non-connection that are not electrically connected to any electrode to be inspected in the wafer, which is the object of inspection, and extend in the thickness-wise direction are formed between the conductive parts 22 for connection located most outside in a direction that the conductive parts 22 for connection are arranged and the frame plate 10. These conductive parts 26 for non-connection contain the conductive particles exhibiting magnetism at a high density in a state oriented so as to align in the thickness-wise direction and are mutually insulated from the conductive parts 22 for connection by an insulating part 23, in which the conductive particles are not contained at all or scarcely contained.
   At the peripheral edge of the functional part 21, a part 25 to be supported that is fixed to and supported by the peripheral edge about the anisotropically conductive film-arranging hole 11 in the frame plate 10 is formed integrally and continuously with the functional part 21, and the conductive particles are contained in this part 25 to be supported.
   Other constitutions are basically the same as those in the anisotropically conductive connector shown in Figs. 1 to 4.
   The anisotropically conductive connector shown in Figs. 15 and 16 can be produced in a similar manner to the process for producing the anisotropically conductive connector shown in Figs. 1 to 4 by using a mold composed of a top force and a bottom force, on which ferromagnetic substance layers have been respectively formed in accordance with a pattern corresponding to an arrangement pattern of the conductive parts 22 for connection and conductive parts 26 for non-connection in the elastic anisotropically conductive films 20 to be formed, and non-magnetic substance layers have been formed at other portions than the ferromagnetic substance layers, in place of the mold shown in Fig. 6.
   More specifically, according to such a mold, a pair of, for example, electromagnets are arranged on an upper surface of a base plate in the top force and a lower surface of a base plate in the bottom force, and the electromagnets are operated, whereby in molding material layers formed between the top force and the bottom force, conductive particles dispersed in portions to become the functional parts 21 in the molding material layers are gathered to portions to become the conductive parts 22 for connection and the portions to become the conductive parts 26 for non-connection, and oriented so as to align in the thickness-wise direction. On the other hand, the conductive particles located above and below the frame plate 10 in the molding material layers remain retained above and below the frame plate 10.
   In this state, the molding material layers are subjected to a curing treatment, whereby the elastic anisotropically conductive films 20 each composed of the functional part 21, in which a plurality of the conductive parts 22 for connection and the conductive parts 26 for non-connection, in which the conductive particles are contained in the elastic polymeric substance in a state oriented so as to align in the thickness-wise direction, are arranged in a state mutually insulated by the insulating part 23 composed of the elastic polymeric substance, in which the conductive particles are not present at all or scarcely present, and the part 25 to be supported, which is continuously and integrally formed at a peripheral edge of the functional part 21 and in which the conductive particles are contained in the elastic polymeric substance, are formed in a state that the part 25 to be supported has been fixed to the periphery about each anisotropically conductive film-arranging hole 11 of the frame plate 10, thus producing the anisotropically conductive connector.
   The conductive parts 26 for non-connection in the anisotropically conductive connector shown in Fig. 15 are obtained by applying a magnetic field to portions to become the conductive parts 26 for non-connection in each of the molding material layers in the formation of the elastic anisotropically conductive films 20, thereby gathering the conductive particles existing between the two adjoining portions arranged at the greater clearance in the molding material layer, which will become the conductive parts 22 for connection, and the conductive particles existing between the portions located most outside in the molding material layer, which will become the conductive parts 22 for connection, and the frame plate 10 to the portions to become the conductive parts 26 for non-connection, and subjecting the molding material layers to a curing treatment in this state. Thus, the conductive particles are prevented from being gathered in excess to the two adjoining portions arranged at the greater clearance in the molding material layer, which will become the conductive parts 22 for connection, and the portions located most outside in the molding material layer, which will become the conductive parts 22 for connection. Accordingly, even when the elastic anisotropically conductive films 20 to be formed each have at least two conductive parts 22 for connection arranged at a greater clearance, it is surely prevented for these conductive parts 22 for connection to contain an excessive amount of the conductive particles. In addition, even when the elastic anisotropically conductive films 20 to be formed have a comparatively great number of conductive parts 22 for connection, it is surely prevented for the conductive parts 22 for connection located most outside in the elastic anisotropically conductive film 20 to contain an excessive amount of the conductive particles.
(2) In the anisotropically conductive connector according to the present invention, projected parts 24 that the conductive parts 22 for connection and peripheral portions thereof protrude from the surface of any other portion may be formed on one surface of the functional part 21 of the elastic anisotropically conductive film 20 as illustrated in Fig. 17, or projected parts 24 that the conductive parts 22 for connection and peripheral portions thereof protrude from the surface of any other portion may be formed on both surfaces of the functional part 21 of the elastic anisotropically conductive film 20 so far as a ratio of the thickness of the insulating part 23 to the thickness of the conductive parts 22 for connection in the functional part 21 of the elastic anisotropically conductive film 20 is at least 0.9
(3) In the anisotropically conductive connector according to the present invention, a metal layer may be formed on the surfaces of the conductive parts 22 for connection in the elastic anisotropically conductive films 20.
(4) In the anisotropically conductive connector according to the present invention, a DLC layer may be formed on the surfaces of the elastic anisotropically conductive film 20.
(5) When a non-magnetic substance is used as a base material of the frame plate 10 in the production of the anisotropically conductive connector according to the present invention, as a method for applying the magnetic field to portions to become the parts 25 to be supported in the molding material layers 20A, a means of plating peripheral portions of the anisotropically conductive film-arranging holes 11 in the frame plate 10 with a magnetic substance or coating them with a magnetic paint to apply a magnetic field thereto, or a means of forming ferromagnetic substance layers on the mold 60 corresponding to the parts 25 to be supported of the elastic anisotropically conductive films 20 to apply a magnetic field thereto may be utilized.
(6) The use of the spacers is not essential in the formation of the molding material layers, and spaces for forming the elastic anisotropically conductive films may be secured between the top force and bottom force, and the frame plate by any other means.
(7) In the wafer inspection apparatus according to the present invention, the sheet-like connector in the probe member is not essential, and the wafer inspection apparatus may be so constructed that the elastic anisotropically conductive films 20 in the anisotropically conductive connector 2 are brought into contact with a wafer, which is an object of inspection, to achieve electrical connection as illustrated in Figs. 18 and 19.
(8) The anisotropically conductive connector according to the present invention or the probe member according to the present invention may also be used in inspection of a wafer 6, on which integrated circuits having projected electrodes (bumps) formed of gold, solder or the like have been formed as the electrodes 7 to be inspected, as illustrated in Figs. 20 and 21, in addition to the inspection of a wafer, on which integrated circuits having flat electrodes composed of aluminum have been formed.
   Since the electrode formed of gold, solder or the like is resistive to a formation of an oxidized film on the surface thereof compared with the electrode composed of aluminum, there is no need of pressurizing such electrodes under a heavy load required for breaking through the oxidized film in the inspection of the wafer 6, on which the integrated circuit having such projected electrodes as electrodes 7 to be inspected have been formed, and the inspection can be performed in a state that the conductive parts 22 for connection in the anisotropically conductive connector 2 have been brought into direct contact with the electrodes 7 to be inspected without using any sheet-like connector.
   When inspection of a wafer is conducted in a state that conductive parts for connection of an anisotropically conductive connector have been brought into direct contact with projected electrodes, which are electrodes to be inspected, the conductive parts for connection undergo abrasion or permanent compressive deformation by being pressurized with the projected electrodes when the anisotropically conductive connector is used repeatedly. As a result, increase in electric resistance and connection failure to the electrodes to be inspected occur on the conductive parts for connection, so that it has been necessary to replace the anisotropically conductive connector by a new one at a high frequency.
   According to the anisotropically conductive connector according to the present invention or the probe member according to the present invention, however, the necessary conductivity is retained over a long period of time even when the wafer 6, which is an object of inspection, is a wafer having a diameter of 8 inches or 12 inches, on which integrated circuits have been formed at a high degree of integration, and the electrodes 7 to be inspected are projected electrodes, since the anisotropically conductive connector or probe member is high in durability in repeated use, whereby the frequency of replacing the anisotropically conductive connector by a new one becomes low, and so the inspection cost can be reduced.
(9) In the anisotropically conductive connector according to the present invention, the anisotropically conductive film-arranging holes in the frame plate thereof may be formed corresponding to electrode regions, in which electrodes to be inspected have been arranged in a part of integrated circuits formed on a wafer, which is an object of inspection, and the elastic anisotropically conductive films may be arranged in these anisotropically conductive film-arranging holes.
   According to such an anisotropically conductive connector, a wafer can be divided into two or more areas to collectively perform the probe test on integrated circuits formed in each of the divided areas.
   More specifically, it is not essential to collectively perform inspection on all the integrated circuits formed on the wafer in the inspection method for wafers using the anisotropically conductive connector according to the present invention or the probe member according to the present invention.
   In the burn-in test, inspection time required of each of integrated circuits is as long as several hours, and so high time efficiency can be achieved when the inspection is conducted collectively on all integrated circuits formed on a wafer. In the probe test on the other hand, inspection time required of each of integrated circuits is as short as several minutes, and so sufficiently high time efficiency can be achieved even when a wafer is divided into 2 or more areas, and the probe test is conducted collectively on integrated circuits formed in each of the divided areas.
   As described above, according to the method that electrical inspection is conducted every divided area as to integrated circuits formed on a wafer, when the electrical inspection is conducted as to integrated circuits formed at a high degree of integration on a wafer having a diameter of 8 inches or 12 inches, the numbers of inspection electrodes and wirings of the circuit board for inspection used can be reduced compared with the method that the inspection is conducted collectively on all the integrated circuits, whereby the production cost of the inspection apparatus can be reduced.
   Since the anisotropically conductive connector according to the present invention or the probe member according to the present invention is high in durability in repeated use, the frequency of occurrence of trouble with the anisotropically conductive connector and replacement of the same by a new one become low when it is used in the method that the electrical inspection is conducted, as to the integrated circuits formed on a wafer, in every divided area, so that inspection cost can be reduced.
(10) In the anisotropically conductive connector according to the present invention, it is not essential to form the parts 25 to be supported, which are stacked against the frame plate 10 as illustrated in Fig. 4, but the elastic anisotropically conductive film 20 may be supported by the frame plate 10 by bonding a side surface of the elastic anisotropically conductive film 20 to an inner surface of the anisotropically conductive film-arranging hole 11 in the frame plate 10 as illustrated in Fig. 22.

In order to obtain such an anisotropically conductive connector, it is only necessary to form a molding material layers without arranging spacers between the top force and bottom force, and the frame plate in a step of forming the elastic anisotropically conductive films 20.

In such an anisotropically conductive connector, there is no need of arranging spacers between the top force and bottom force, and the frame plate upon the formation of the elastic anisotropically conductive films 20, and the intended thickness of the elastic anisotropically conductive films 20 is determined by the thickness of the frame plate 10 and the depth of the recessed parts formed in the molding surfaces of the mold, so that it is easy to form thin elastic anisotropically conductive films 20 having a thickness of, for example, 100 µm or less.

The present invention will hereinafter be described specifically by the following examples. However, the present invention is not limited to these examples.

### [Production of wafer for evaluation]

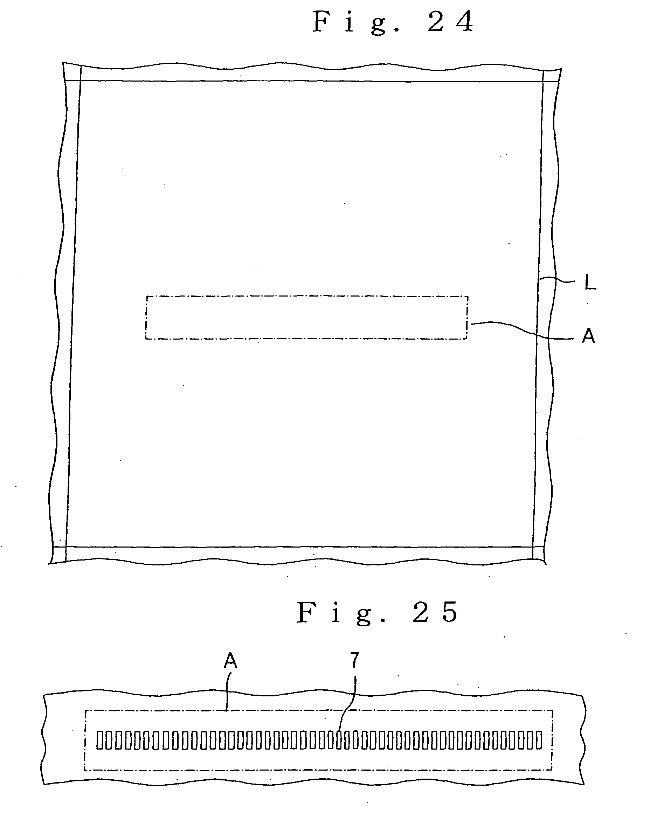

As illustrated in Fig. 23, 393 square integrated circuits L in total, which each had dimensions of 8 mm x 8 mm, were formed on a wafer 6 made of silicon (coefficient of linear thermal expansion: 3.3 x 10⁻⁶/K) and having a diameter of 8 inches. Each of the integrated circuits L formed on the wafer 6 has a region A of electrodes to be inspected at its center as illustrated in Fig. 24. In the region A of the electrodes to be inspected, as illustrated in Fig. 25, 50 rectangular electrodes 7 to be inspected each having dimensions of 200 µm in a vertical direction (upper and lower direction in Fig. 25) and 50 µm in a lateral direction (left and right direction in Fig. 25) are arranged at a pitch of 100 µm in a line in the lateral direction. The total number of the electrodes 7 to be inspected in the whole wafer 6 is 19,650. All the electrodes to be inspected are electrically connected to a common lead electrode (not illustrated) formed at a peripheral edge of the wafer 6. An area S2 of a surface of the wafer 6 on a side that the electrodes 7 to be inspected have been formed is 3.14 x 10⁴ mm². This wafer will hereinafter be referred to as "Wafer W1 for evaluation".

Further, 393 integrated circuits (L), which had the same construction as in the Wafer W1 for evaluation except that no common lead electrode was formed as to 50 electrodes (7) to be inspected in the integrated circuit (L) , and the electrodes to be inspected were electrically insulated from one another, were formed on a wafer (6). The total number of the electrodes to be inspected in the whole wafer is 19,650. An area S2 of a surface of the wafer (6) on a side that the electrodes (7) to be inspected have been formed is 3.14 x 10⁴ mm². This wafer will hereinafter be referred to as "Wafer W2 for evaluation".

### [Production of wafer for test]

On a wafer (6), 393 integrated circuits (L), which had the same construction as in the Wafer W1 for evaluation except that every two electrodes (7) to be inspected were electrically connected to each other on every other electrode counting from an endmost electrode (7) to be inspected among 50 electrodes (7) to be inspected in the integrated circuit (L), and no lead electrode was formed, were formed. The total number of the electrodes to be inspected in the whole wafer is 19,650. Hereinafter, the total number of electrodes to be inspected in the whole wafer is 19,650. An area S2 of a surface of the wafer (6) on a side that the electrodes (7) to be inspected have been formed is 3.14 x 10⁴ mm². This wafer will hereinafter be referred to as "Wafer W3 for test".

Further, 393 integrated circuits (L), which had the same construction as in the Wafer W1 for evaluation except that every two electrodes (7) to be inspected were electrically connected to each other on every other electrode counting from an endmost electrode (7) to be inspected among 50 electrodes (7) to be inspected in the integrated circuit (L), no lead electrode was formed, and the electrodes to be inspected were changed to projected electrodes having a diameter of 70 µm and a height of 30 µm, were formed on a wafer (6). The total number of the electrodes to be inspected in the whole wafer is 19,650. An area S2 of a surface of the wafer (6) on a side that the electrodes (7) to be inspected have been formed is 3.14 x 10⁴ mm². This wafer will hereinafter be referred to as "Wafer W4 for test".

### <Examples and Comparative Examples>

### (1) Preparation of conductive particles:

Into a treating vessel of a powder plating apparatus, were poured 100 g of particles composed of nickel (saturation magnetization: 0.6 Wb/m²) and having a number average particle diameter of 10 µm, and 2 L of 0.32N hydrochloric acid were further added. The resultant mixture was stirred to obtain a slurry containing core particles. This slurry was stirred at ordinary temperature for 30 minutes, thereby conducting an acid treatment of the core particles. Thereafter, the slurry thus treated was left at rest for 1 minute to precipitate the core particles, and a supernatant was removed.

To the core particles subjected to the acid treatment, were added 2 L of purified water, and the mixture was stirred for 2 minutes at ordinary temperature. The mixture was then left at rest for 1 minute to precipitate magnetic core particles, and a supernatant was removed. This process was conducted repeatedly twice, thereby conducting a washing treatment of core particles.

To the core particles subjected to the acid treatment and washing treatment, were added 2 L of a gold plating solution containing gold in a proportion of 20 g/L. The temperature in the treating vessel was raised to 90°C and the mixture was stirred, thereby preparing a slurry. While stirring the slurry in this state, the core particles were subjected to displacement plating with gold. Thereafter, the slurry was left at rest while allowing it to cool, thereby precipitating particles, and a supernatant was removed to prepare conductive particles with the surfaces of the core particles composed of nickel plated with gold.

To the conductive particles obtained in such a manner, were added 2 L of purified water, and the mixture was stirred at ordinary temperature for 2 minutes. Thereafter, the mixture was left at rest for 1 minute to precipitate the conductive particles, and a supernatant was removed. This process was repeated additionally twice, 2 L of purified water heated to 90°C were then added to the particles, and the mixture was stirred. The resultant slurry was filtered through filter paper to collect the conductive particles. The conductive particles were subjected to a drying treatment by means of a dryer preset to 90°C.

An air classifier "Turboclassifier TC-15N" (manufactured by Nisshin Engineering Co., Ltd.) was then used to subject 200 g of the conductive particles to a classification treatment under conditions of a specific gravity of 8.9, an air flow of 2.5 m³/min, a rotor speed of 1,600 rpm, a classification point of 25 µm and a feed rate of the conductive particles of 16 g/min, thereby collecting 180 g of conductive particles. Further, 180 g of the conductive particles were subjected to another classification treatment under conditions of a specific gravity of 8.9, an air flow of 25 m³/min, a rotor speed of 3,000 rpm, a classification point of 10 µm and a feed rate of the conductive particles of 14 g/min to collect 150 g of conductive particles.

The conductive particles thus obtained were such that the number average particle diameter was 8.7 µm, the weight average particle diameter was 9.9 µm, the ratio Dw/Dn value was 1.1, the standard deviation of the particle diameter was 2.0, the coefficient of variation of the particle diameter was 23%, and the proportion of gold to the core particles was 30% by mass. The conductive particles are referred to as "Conductive Particles (a)".

### (2) Production of frame plate:

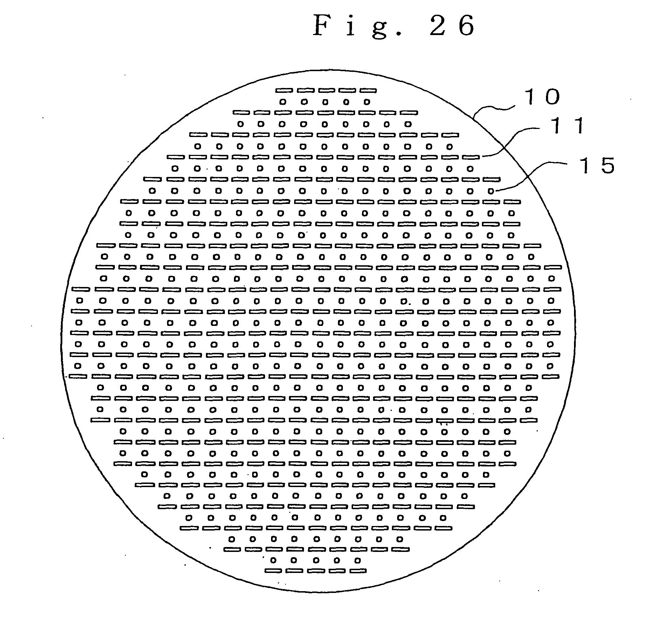

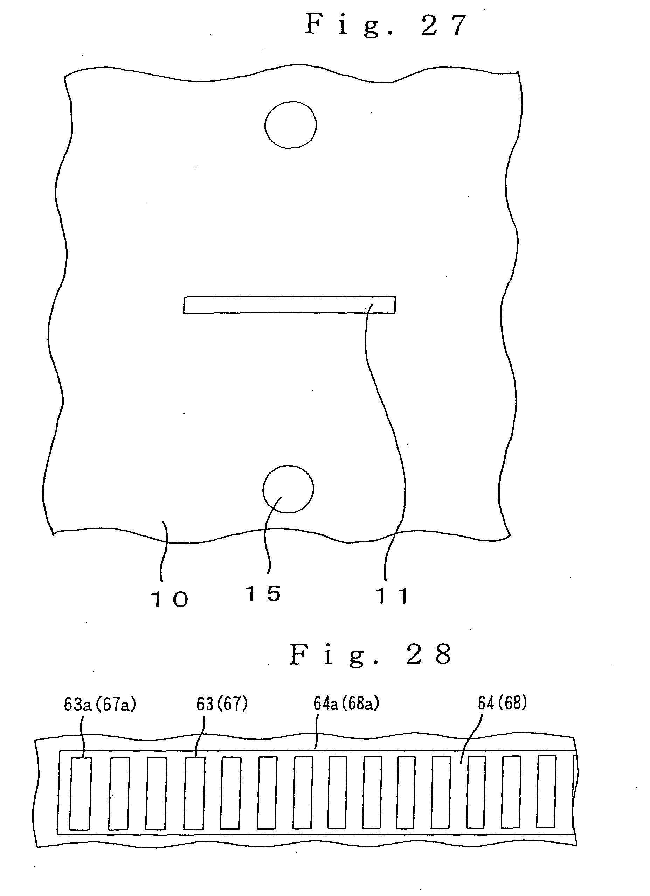

Twenty frame plates in total, each having a diameter of 8 inches and 393 anisotropically conductive film-arranging holes formed corresponding to the respective regions of the electrodes to be inspected in Wafer W1 for evaluation, were produced under the following conditions in accordance with the construction shown in Figs. 26 and 27.

A material of this frame plate 10 is covar (saturation magnetization: 1.4 Wb/m²; coefficient of linear thermal expansion: 5 x 10⁻⁶/K), and the thickness thereof is 50 µm.

Each of the anisotropically conductive film-arranging holes 11 has dimensions of 5,500 µm in a lateral direction (left and right direction in Figs. 26 and 27) and 320 µm in a vertical direction (upper and lower direction in Figs. 26 and 27) .

A circular air circulating hole 15 is formed at a central position between anisotropically conductive film-arranging holes 11 adjoining in the vertical direction, and the diameter thereof is 1,000 µm.

### (3) Production of spacer:

Two spacers for molding elastic anisotropically conductive films, which each have a plurality of through-holes formed corresponding to the regions of the electrodes to be inspected in Wafer W1 for evaluation, were produced under the following conditions. A material of these spacers is stainless steel (SUS304), and the thickness thereof is 10 µm.

The through-hole corresponding to each region of the electrodes to be inspected has dimensions of 6,000 µm in the lateral direction and 1,200 µm in the vertical direction.

### (4) Production of mold:

A mold (K1) for molding elastic anisotropically conductive films was produced under the following conditions in accordance with the construction shown in Figs. 7 and 28.

A top force 61 and a bottom force 65 in this mold (K1) respectively have base plates 62 and 66 made of iron and each having a thickness of 6 mm. On the base plates 62 and 66, ferromagnetic substance layers 63 (67) for forming conductive parts for connection and ferromagnetic substance layers 63a (67a) for forming conductive parts for non-connection, which are made of nickel, are arranged in accordance with a pattern corresponding to a pattern of the electrodes to be inspected in Wafer W1 for evaluation. More specifically, the dimensions of each of the ferromagnetic substance layers 63 (67) for forming conductive parts for connection are 40 µm (lateral direction) x 200 µm (vertical direction) x 100 µm (thickness), and 50 ferromagnetic substance layers 63 (67) are arranged at a pitch of 100 µm in a line in the lateral direction. The ferromagnetic substance layers 63a (67a) for forming conductive parts for non-connection are arranged outside the ferromagnetic substance layers 63 (67) located most outside in a direction that the ferromagnetic substance layers 63 (67) are arranged. The dimensions of each of the ferromagnetic substance layers 63a (67a) are 40 µm (lateral direction) x 200 µm (vertical direction) x 100 µm (thickness).

Corresponding to the regions of the electrodes to be inspected in Wafer W1 for evaluation, are formed 393 regions in total, in each of which 50 ferromagnetic substance layers 63 (67) for forming conductive parts for connection and 2 ferromagnetic substance layers 63a (67a) for forming conductive parts for non-connection have been formed. In the whole base plate, are formed 19,650 ferromagnetic substance layers 63 (67) for forming conductive parts for connection and 786 ferromagnetic substance layers 63a (67a) for forming conductive parts for non-connection. Non-magnetic substance layers 64 (68) are formed by subjecting a dry film resists to a curing treatment. The dimensions of each of recessed parts 64a (68a) for forming functional parts are 5,250 µm (lateral direction) x 210 µm (vertical direction) x 25 µm (depth), and the thickness of other portions than the recessed parts is 125 µm (the thickness of the recessed parts: 100 µm).

A mold (K2) for molding elastic anisotropically conductive films was produced under the following conditions in accordance with the construction shown in Figs. 29 and 30.

A top force 61 and a bottom force 65 in this mold (K2) respectively have base plates 62 and 66 made of iron and each having a thickness of 6 mm. On the base plates 62 and 66, ferromagnetic substance layers 63 (67) for forming conductive parts for connection and ferromagnetic substance layers 63a (67a) for forming conductive parts for non-connection, which are made of nickel, are arranged in accordance with a pattern corresponding to a pattern of the electrodes to be inspected in Wafer W1 for evaluation. More specifically, the dimensions of each of the ferromagnetic substance layers 63 (67) for forming conductive parts for connection are 40 µm (lateral direction) x 200 µm (vertical direction) x 100 µm (thickness), and 50 ferromagnetic substance layers 63 (67) are arranged at a pitch of 100 µm in a line in the lateral direction. The ferromagnetic substance layers 63a (67a) for forming conductive parts for non-connection are arranged outside the ferromagnetic substance layers 63 (67) located most outside in a direction that the ferromagnetic substance layers 63 (67) are arranged. The dimensions of each of the ferromagnetic substance layers 63a (67a) are 40 µm (lateral direction) x 200 µm (vertical direction) x 100 µm (thickness).

Corresponding to the regions of the electrodes to be inspected in Wafer W1 for evaluation, are formed 393 regions in total, in each of which 50 ferromagnetic substance layers 63 (67) for forming conductive parts for connection and 2 ferromagnetic substance layers 63a (67a) for forming conductive parts for non-connection have been formed. In the whole base plate, are formed 19,650 ferromagnetic substance layers 63 (67) for forming conductive parts for connection and 786 ferromagnetic substance layers 63a (67a) for forming conductive parts for non-connection. Non-magnetic substance layers 64 (68) are formed by subjecting a dry film resists to a curing treatment. At regions, in which the ferromagnetic substance layers 63 (67) for forming conductive parts for connection are located, and regions, in which the ferromagnetic substance layers 63a (67a) for forming conductive parts for non-connection are located, are formed recessed parts 64b (68b) and 64c (68c) for forming projected parts on an elastic anisotropically conductive film. The dimensions of each of the recessed parts 64b (68b), at which the ferromagnetic substance layers 63 (67) for forming conductive parts for connection are located, are 60 µm (lateral direction) x 210 µm (vertical direction) x 25 µm (depth), and the dimensions of each of the recessed parts 64c (68c), at which the ferromagnetic substance layers 63a (67a) for forming conductive parts for non-connection are located, are 90 µm (lateral direction) x 260 µm (vertical direction) x 25 µm (depth), and the thickness of other portions than the recessed parts is 125 µm (the thickness of the recessed parts: 100 µm).

### (5) Production of anisotropically conductive connector: [Production of Anisotropically Conductive Connectors (A1) to (A10) ]

The above-described frame plate, spacers and mold were used to form elastic anisotropically conductive films in the frame plate in the following manner.

To and with 100 parts by mass of addition type liquid silicone rubber were added and mixed 30 parts by mass of Conductive Particles (a). Thereafter, the resultant mixture was subjected to a defoaming treatment by pressure reduction, thereby preparing a molding material for molding elastic anisotropically conductive films.

In the above-described process, liquid silicone rubber of a two-pack type that the viscosity of Solution A is 250 Pa·s, the viscosity of Solution B is 250 Pa·s, the compression set of a cured product thereof at 150°C is 5%, the durometer A hardness of the cured product is 32, and the tear strength of the cured product is 25 kN/m was used as the addition type liquid silicone rubber.

The properties of the addition type liquid silicone rubber were determined in the following manner.
(i) Viscosity of addition type liquid silicone rubber:
   A viscosity at 23 ± 2°C was measured by a Brookfield viscometer.
(ii) Compression set of cured product of silicone rubber:
   Solution A and Solution B in addition type liquid silicone rubber of the two-pack type were stirred and mixed in proportions that their amounts become equal. After this mixture was then poured into a mold and subjected to a defoaming treatment by pressure reduction, a curing treatment was conducted under conditions of 120°C for 30 minutes, thereby producing a columnar body having a thickness of 12.7 mm and a diameter of 29 mm and composed of a cured product of the silicone rubber. The columnar body was post-cured under conditions of 200°C for 4 hours. The columnar body obtained in such a manner was used as a specimen to measure its compression set at 150 ± 2°C in accordance with JIS K 6249.
(iii) Tear strength of cured product of silicone rubber:
   A curing treatment and post-curing of addition type liquid silicone rubber were conducted under the same conditions as in the item (ii), thereby producing a sheet having a thickness of 2.5 mm. A crescent type specimen was prepared by punching from this sheet to measure its tear strength at 23 ± 2°C in accordance with JIS K 6249.
(iv) Durometer A hardness:
   Five sheets produced in the same manner as in the item (iii) were stacked on one another, and the resultant laminate was used as a specimen to measure its durometer A hardness at 23 ± 2°C in accordance with JIS K 6249.

The molding material prepared was applied to the surfaces of the top force and bottom force of the above-described mold by screen printing, thereby forming molding material layers in accordance with a patter of elastic anisotropically conductive films to be formed, and the frame plate was superimposed in alignment on the molding surface of the bottom force through the spacer for the side of the bottom force. Further, the top force was superimposed in alignment on the frame plate through the spacer for the side of the top force.

The molding material layers formed between the top force and the bottom force were subjected to a curing treatment under conditions of 100°C for 1 hour while applying a magnetic field of 2 T to portions located between the ferromagnetic substance layers in a thickness-wise direction by electromagnets, thereby forming an elastic anisotropically conductive film in each of the anisotropically conductive film-arranging holes of the frame plate.

The elastic anisotropically conductive films thus obtained will be described specifically. The total number of the elastic anisotropically conductive films in the anisotropically conductive connector is 393, and each of the elastic anisotropically conductive films has dimensions of 6,000 µm in the lateral direction and 1,200 µm in the vertical direction.

A functional part in each of the elastic anisotropically conductive films has dimensions of 5,250 µm in the lateral direction and 210 µm in the vertical direction, and an area of one surface thereof is 1.1025 mm² Accordingly, a sum total S1 of areas of one surfaces of the functional parts of all the elastic anisotropically conductive films is 433 mm², and a ratio S1/S2 of the sum total S1 of areas of one surfaces of the functional parts of all the elastic anisotropically conductive films to the area S2 of the surface of Wafer W1 for evaluation on a side that the electrodes to be inspected have been formed is 0.0138.

In the functional part in each of the elastic anisotropically conductive films, 50 conductive parts for connection are arranged at a pitch of 100 µm in a line in the lateral direction. The dimensions of each of the conductive parts for connection are 120 µm in thickness, 40 µm in the lateral direction and 200 µm in the vertical direction. In the functional part, conductive parts for non-connection are arranged between the conductive parts for connection located most outside in the lateral direction and the frame plate. The dimensions of each of the conductive parts for non-connection are 40 µm in the lateral direction and 200 µm in the vertical direction. The thickness of the insulating part in the functional part is 120 µm. A ratio (T2/T1) of the thickness of the insulating part to the thickness of the conductive parts for connection is 1. Accordingly, each of the functional parts is flat in both surfaces and has an even thickness. Each of the functional parts is formed in such a manner that both surfaces thereof protrude from a part to be supported, and a projected height of the functional part is 25 µm. The overall thickness of the part to be supported in each of the elastic anisotropically conductive films is 70 µm, and the thickness of one of the forked portions is 10 µm .

Elastic anisotropically conductive films were respectively formed in 10 frame plates in the above-described manner to produce a total of 10 anisotropically conductive connectors. These anisotropically conductive connectors will hereinafter be referred to as Anisotropically Conductive Connector (A1) to Anisotropically Conductive Connector (A10).

The parts to be supported and the insulating parts in the functional parts of the elastic anisotropically conductive films were observed. As a result, it was confirmed that the conductive particles are present in the parts to be supported and that the conductive particles are scarcely present in the insulating parts in the functional parts.

### [Production of Anisotropically Conductive Connectors (B1) to (B10)]

Ten anisotropically conductive connectors for comparison were produced in the same manner as in Anisotropically Conductive Connectors (A1) to (A10) except that the mold (K2) was used in place of the mold (K1) .

The elastic anisotropically conductive films of the anisotropically conductive sheets thus obtained will be described specifically. The total number of the elastic anisotropically conductive films in the anisotropically conductive connector is 393, and each of the elastic anisotropically conductive films has dimensions of 6,000 µm in the lateral direction and 1,200 µm in the vertical direction. Fifty conductive parts for connection are arranged at a pitch of 100 µm in a line in the lateral direction. The dimensions of each of the conductive parts for connection are 40 µm in the lateral direction, 200 µm in the vertical direction and 120 µm in thickness. Conductive parts for non-connection are arranged between the conductive parts for connection located most outside in the lateral direction and the frame plate. The dimensions of each of the conductive parts for non-connection are 40 µm in the lateral direction, 200 µm in the vertical direction and 120 µm in thickness. The projected height of the projected parts formed on the conductive parts for connection is 25 µm in each surface, and each projected part has dimensions of 60 µm in the lateral direction and 210 µm in the vertical direction. The projected height of the projected parts formed on the conductive parts for non-connection is 25 µm in each surface, and each projected part has dimensions of 90 µm in the lateral direction and 260 µm in the vertical direction. Accordingly, a sum total of areas of end surfaces of the projected parts in all the elastic anisotropically conductive films is 266 mm², and a ratio of the sum total of areas of end surfaces of the projected parts in all the elastic anisotropically conductive films to the area of the surface of Wafer W1 for evaluation on a side that the electrodes to be inspected have been formed is 0.0085. The thickness of the insulating part is 70 µm, and a ratio (T2/T1) of the thickness of the insulating part to the thickness of the conductive parts for connection is 0.58. The thickness (thickness of one of the forked portions) of the part to be supported in each of the elastic anisotropically conductive films is 10 µm.

These anisotropically conductive connectors will hereinafter be referred to as Anisotropically Conductive Connector (B1) to Anisotropically Conductive Connector (B10) .

### (6) Circuit board for inspection:

Alumina ceramic (coefficient of linear thermal expansion: 4.8 x 10⁻⁶/K) was used as a base material to produce a circuit board for inspection, in which inspection electrodes had been formed in accordance with a pattern corresponding to the pattern of the electrodes to be inspected in Wafer W1 for evaluation. This circuit board for inspection is rectangular having dimensions of 30 cm x 30 cm as a whole and. The inspection electrodes thereof each have dimensions of 60 µm in the lateral direction and 200 µm in the vertical direction. This circuit board for inspection will hereinafter be referred to as "Circuit Board T for inspection".

### (7) Sheet-like connector:

A laminate material obtained by laminating a copper layer having a thickness of 15 µm on one surface of an insulating sheet formed of polyimide and having a thickness of 20 µm was provided, and the insulating sheet in this laminate material was subjected to laser machining, thereby forming 19,650 through-holes each extending through in a thickness-wise direction of the insulating sheet and having a diameter of 30 µm in the insulating sheet in accordance with a pattern corresponding to the pattern of the electrodes to be inspected in Wafer W1 for evaluation. This laminate material was then subjected to photolithography and a nickel plating treatment, thereby forming short circuit parts integrally connected to the copper layer in the through-holes in the insulating sheet, and at the same time, forming projected front-surface electrode parts integrally connected to the respective short circuit parts on the front surface of the insulating sheet. The diameter of each of the front-surface electrode parts was 40 µm, and the height from the surface of the insulating sheet was 20 µm. Thereafter, the copper layer of the laminate material was subjected to a photo-etching treatment to remove a part thereof, thereby forming rectangular back-surface electrode parts each having dimensions of 60 µm x 210 µm. Further, the front-surface electrode parts and back-surface electrode parts were subjected to a gold plating treatment, thereby forming electrode structures, thus producing a sheet-like connector. This sheet-like connector will hereinafter be referred to as "Sheet-like Connector M".

### (8) Initial properties of elastic anisotropically conductive film:

The initial properties of elastic anisotropically conductive films in each of Anisotropically Conductive Connectors (A1) to (A10) and Anisotropically Conductive Connectors (B1) to (B10) were determined in the following manner.

An anisotropically conductive connector was arranged on Circuit Board T for inspection in alignment in such a manner that the conductive parts for connection thereof are located on the respective inspection electrodes of Circuit Board T for inspection, and a peripheral portion of the anisotropically conductive connector was bonded to Circuit Board T for inspection with RTV silicone rubber to produce a probe member. This probe member was then fixed to a pressurizing plate, and Wafer W1 for evaluation was mounted on a wafer mounting table. A CCD camera capable of viewing both upper and lower directions was advanced between the probe member and Wafer W1 for evaluation, and alignment of Wafer W1 for evaluation was conducted to the probe member in accordance with the images of this CCD camera in such a manner that the conductive parts for connection of the anisotropically conductive connector are respectively located right over the electrodes to be inspected of Wafer W1 for evaluation. The CCD camera was then removed from between the probe member and Wafer W1 for evaluation, and the probe member was pressurized downward under a load of 58.95 kg (load applied to every conductive part for connection: 3 g on the average), thereby bringing the elastic anisotropically conductive films of the anisotropically conductive connector into contact under pressure with Wafer W1 for evaluation. An electric resistance between each of the 19,650 inspection electrodes in Circuit Board T for evaluation and the lead electrode of Wafer W1 for evaluation was successively measured at room temperature (25°C) as an electric resistance (hereinafter referred to as "conduction resistance") in the conductive part for connection to calculate out a proportion of conductive parts for connection that the conduction resistance was lower than 1 Ω.

Wafer W2 for evaluation was mounted in place of Wafer W1 for evaluation on the wafer mounting table, a CCD camera capable of viewing both upper and lower directions, was advanced between the probe member and Wafer W2 for evaluation, and alignment of Wafer W2 for evaluation was conducted to the probe member in accordance with the images of this CCD camera in such a manner that the conductive parts for connection of the anisotropically conductive connector are respectively located right over the electrodes to be inspected of Wafer W2 for evaluation. The CCD camera was then removed from between the probe member and Wafer W2 for evaluation, and the probe member was pressurized downward under a load of 58.95 kg (load applied to every conductive part for connection: 3 g on the average), thereby bringing the elastic anisotropically conductive films of the anisotropically conductive connector into contact under pressure with Wafer W2 for evaluation. An electric resistance between adjoining 2 inspection electrodes in Circuit Board T for evaluation was successively measured at room temperature (25°C) as an electric resistance (hereinafter referred to as "insulation resistance") between adjoining 2 conductive parts for connection (hereinafter referred to as "pairs of conductive parts") to calculate out a proportion of pairs of conductive parts that the insulation resistance was 10 MΩ or higher.

The results are shown in Table 1.

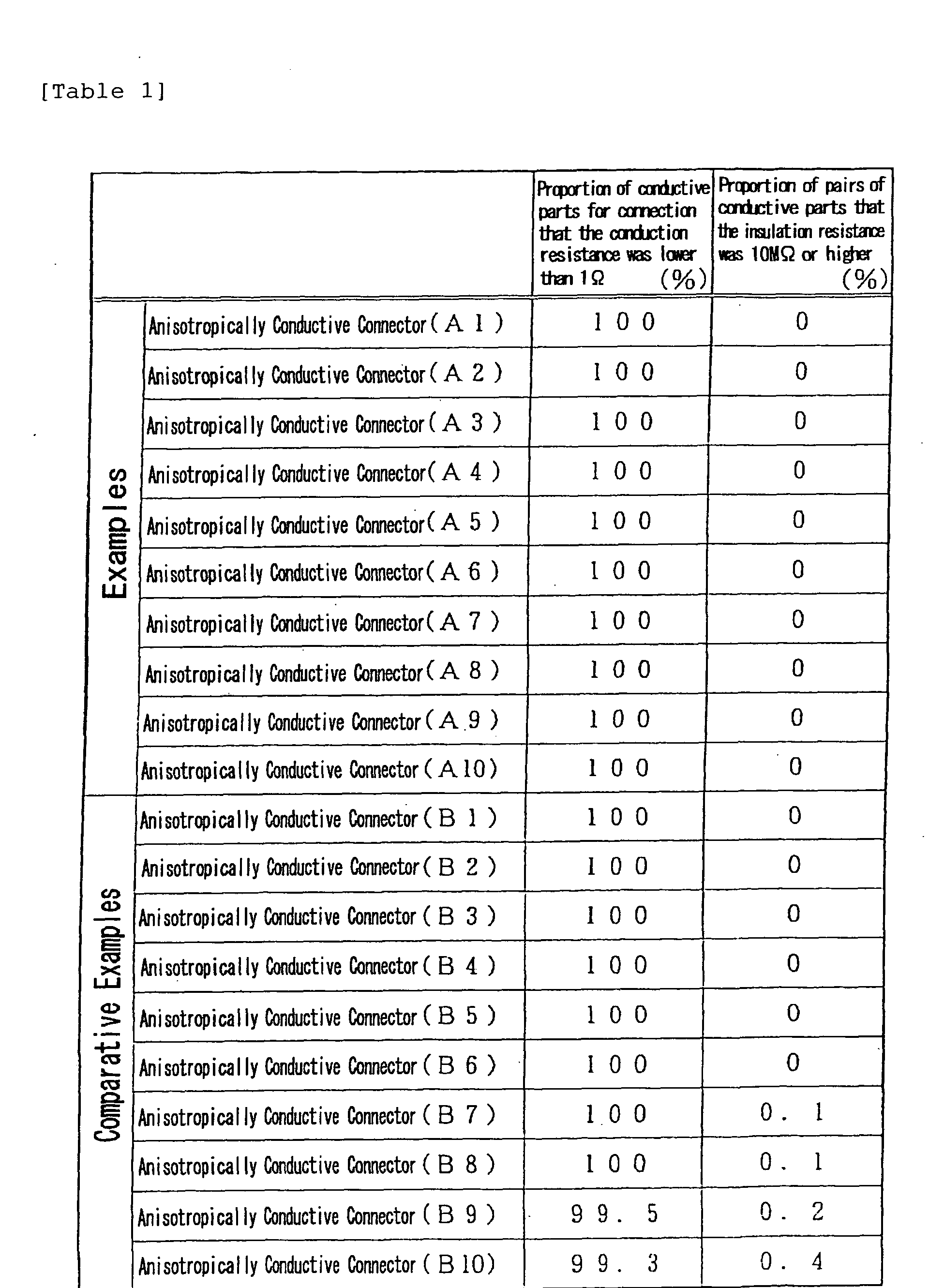

### (9) Test 1:

A durability test under a high-temperature environment was conducted as to Anisotropically Conductive Connector (A1), Anisotropically Conductive Connector (A2), Anisotropically Conductive Connector (B1) and Anisotropically Conductive Connector (B2) in the following manner.

An anisotropically conductive connector was arranged on Circuit Board T for inspection in alignment in such a manner that the conductive parts for connection thereof are located on the respective inspection electrodes of Circuit Board T for inspection, and a peripheral portion of the anisotropically conductive connector was bonded to Circuit Board T for inspection with RTV silicone rubber to produce a probe member. This probe member was then fixed to a pressurizing plate, and Wafer W4 for test was mounted on a wafer mounting table equipped with an electric heater. A CCD camera capable of viewing both upper and lower directions was advanced between the probe member and Wafer W4 for test, and alignment of Wafer W4 for test was conducted to the probe member in accordance with the images of this CCD camera in such a manner that the conductive parts for connection of the anisotropically conductive connector are respectively located right over the electrodes to be inspected of Wafer W4 for test. The CCD camera was then removed from between the probe member and Wafer W4 for test, and the probe member was pressurized downward under a load of 158 kg (load applied to every conductive part for connection: 8 g on the average) , thereby bringing the elastic anisotropically conductive films of the anisotropically conductive connector into contact under pressure with Wafer W4 for test. The wafer mounting table was then heated to 125°C. After the temperature of the wafer mounting table became stable, an electric resistance between 2 inspection electrodes electrically connected to each other through the anisotropically conductive connector and Wafer W4 for test among the 19,650 inspection electrodes in Circuit Board T for inspection was successively measured to record a half value of the electric resistance value measured as a conduction resistance of the conductive part for connection in the anisotropically conductive connector, thereby counting the number of conductive parts for connection that the conduction resistance was 1 Ω or higher. Thereafter, the wafer mounting table was left to stand for 1 hour in this state and then cooled to room temperature. Thereafter, the pressure against the probe member was released.

The above-described process was regarded as a cycle, and the cycle was continuously repeated 500 times in total.

In the above-described test, those that the conduction resistance of the conductive part for connection is 1 Ω or higher are difficult to be actually used in electrical inspection of integrated circuits formed on a wafer.

The results are shown in Table 2.

### (10) Test 2:

A durability test under a high-temperature environment was conducted as to Anisotropically Conductive Connector (A3), Anisotropically Conductive Connector (A4), Anisotropically Conductive Connector (B3) and Anisotropically Conductive Connector (B4) in the following manner.

An anisotropically conductive connector was arranged on Circuit Board T for inspection in alignment in such a manner that the conductive parts for connection thereof are located on the respective inspection electrodes of Circuit Board T for inspection, a peripheral portion of the anisotropically conductive connector was bonded to Circuit Board T for inspection with RTV silicone rubber, Sheet-like Probe M was arranged on this anisotropically conductive connector in alignment in such a manner that the back-surface electrode parts thereof are located on the respective conductive parts for connection of the anisotropically conductive connector, and a peripheral portion of Sheet-like Connector M was bonded to Circuit Board T for inspection with RTV silicone rubber to produce a probe member. This probe member was then fixed to a pressurizing plate, and Wafer W3 for test was mounted on a wafer mounting table equipped with an electric heater. A CCD camera capable of viewing both upper and lower directions was advanced between the probe member and Wafer W3 for test, and alignment of Wafer W3 for test was conducted to the probe member in accordance with the images of this CCD camera in such a manner that the front-surface electrode parts of the sheet-like connector are respectively located right over the electrodes to be inspected of Wafer W3 for test. The CCD camera was then removed from between the probe member and Wafer W3 for test, and the probe member was pressurized downward under a load of 158 kg (load applied to every conductive part for connection: 8 g on the average), thereby bringing the elastic anisotropically conductive films of the anisotropically conductive connector into contact under pressure with Wafer W4 for test. The wafer mounting table was then heated to 125°C. After the temperature of the wafer mounting table became stable, an electric resistance between 2 inspection electrodes electrically connected to each other through the anisotropically conductive connector, Sheet-like Connector M and Wafer W3 for test among the 19,650 inspection electrodes in Circuit Board T for inspection was successively measured to record a conduction resistance of the conductive part for connection in the anisotropically conductive connector, thereby counting the number of conductive parts for connection that the conduction resistance was 1 Ω or higher. Thereafter, the wafer mounting table was left to stand for 1 hour in this state and then cooled to room temperature. Thereafter, the pressure against the probe member was released.

The above-described process was regarded as a cycle, and the cycle was continuously repeated 500 times in total.

In the above-described test, those that the conduction resistance of the conductive part for connection is 1 Ω or higher are difficult to be actually used in electrical inspection of integrated circuits formed on a wafer.

The results are shown in Table 3.

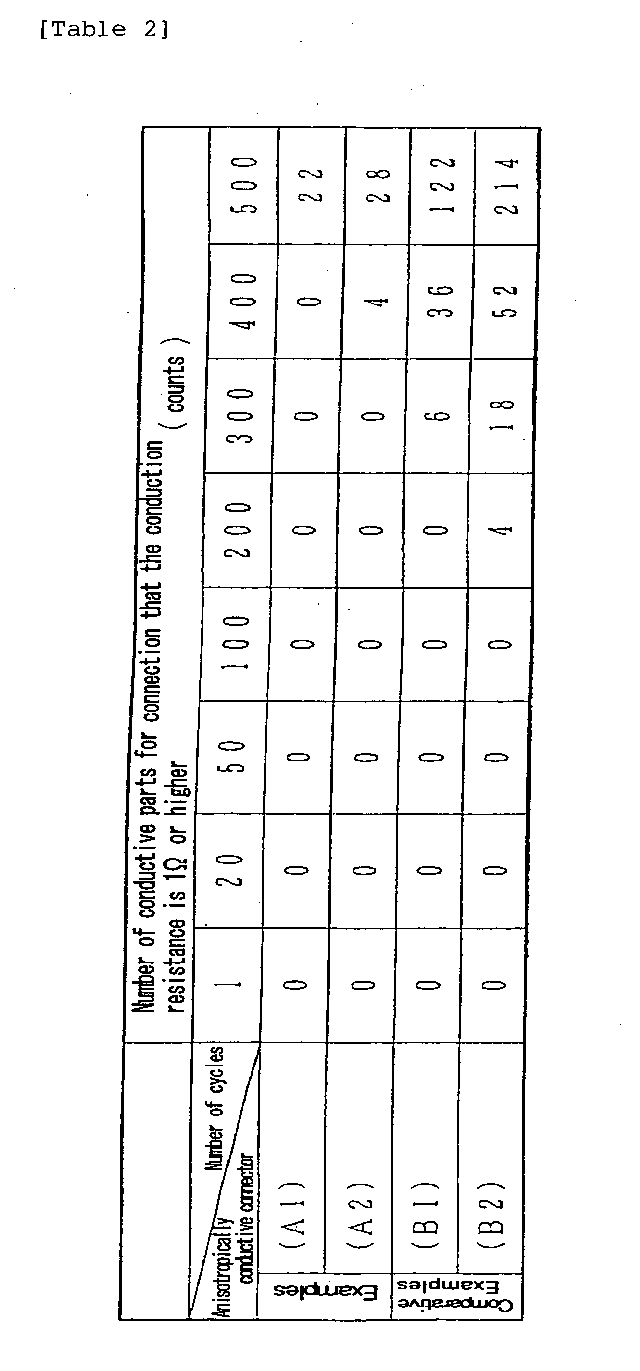

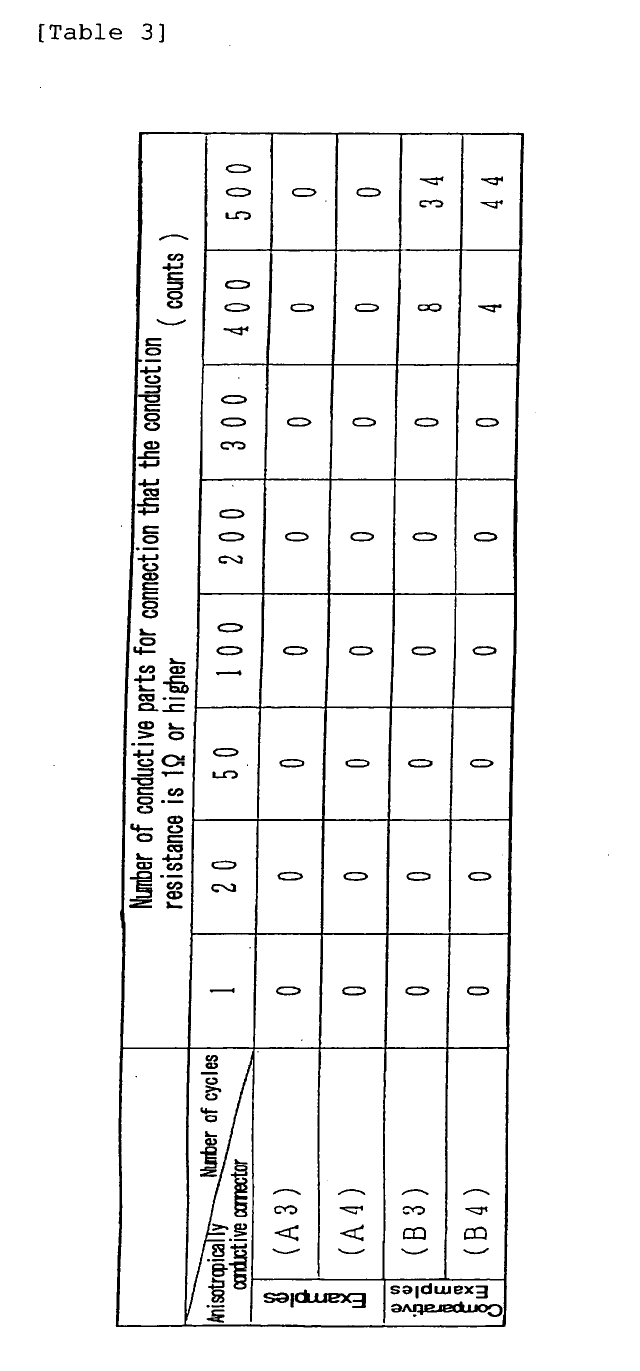

As apparent from the results shown in Tables 1 to 3, it was confirmed that according to the anisotropically conductive connectors related to Examples, good conductivity is achieved on the conductive parts for connection in the elastic anisotropically conductive films even when the pitch of the conductive parts for connection is small, and moreover that a good electrically connected state is stably retained even by environmental changes such as thermal hysteresis by temperature change, and good conductivity is retained over a long period of time even when they are used repeatedly under a high temperature environment. It was also confirmed that according to the anisotropically conductive connectors related to Examples, high durability in repeated use is attained even when a wafer, which is an object of inspection, has a great number of electrodes to be inspected, and these electrodes to be inspected are projected electrodes.

## Claims

1. An anisotropically conductive connector comprising elastic anisotropically conductive films each having a functional part, in which a plurality of conductive parts for connection containing conductive particles and extending in a thickness-wise direction of the film have been arranged in a state mutually insulated by an insulating part,
wherein assuming that a thickness of the conductive parts for connection in the functional part of the elastic anisotropically conductive film is T1 and a thickness of the insulating part in the functional part is T2, a ratio (T2/T1) is at least 0.9.

2. An anisotropically conductive connector suitable for use in conducting electrical inspection of each of a plurality of integrated circuits formed on a wafer in a state of the wafer, which comprises:
a frame plate, in which a plurality of anisotropically conductive film-arranging holes each extending through in a thickness-wise direction of the frame plate have been formed corresponding to electrode regions, in which electrodes to be inspected have been arranged, in all or part of the integrated circuits formed on the wafer, which is an object of inspection, and a plurality of elastic anisotropically conductive films arranged in the respective anisotropically conductive film-arranging holes in this frame plate and each supported by the peripheral part about the anisotropically conductive film-arranging hole,
wherein each of the elastic anisotropically conductive films is equipped with a functional part having a plurality of conductive parts for connection arranged corresponding to the electrodes to be inspected in the integrated circuits formed on the wafer, which is the object of inspection, containing conductive particles exhibiting magnetism at a high density and extending in a thickness-wise direction of the film, and an insulating part mutually insulating these conductive parts for connection, and
wherein assuming that a thickness of the conductive parts for connection in the functional part of the elastic anisotropically conductive film is T1 and a thickness of the insulating part in the functional part is T2, a ratio (T2/T1) is at least 0.9.

3. The anisotropically conductive connector according to claim 2, wherein at least one surface of the functional part in each of the elastic anisotropically conductive films is flat.

4. The anisotropically conductive connector according to claim 3, wherein said at least one flat surface of the functional part in each of the elastic anisotropically conductive films is formed so as to project from any other portion, and
wherein assuming that a sum total of areas of one surfaces of the functional parts of all the elastic anisotropically conductive films is S1, and an area of a surface of the wafer, which is the object of inspection, on a side that the electrodes to be inspected have been formed, is S2, a ratio S1/S2 is 0.001 to 0.3.

5. The anisotropically conductive connector according to any one of claims 2 to 4, wherein the coefficient of linear thermal expansion of the frame plate is at most 3 x 10⁻⁵/K.

6. A probe member suitable for use in conducting electrical inspection of each of a plurality of integrated circuits formed on a wafer in a state of the wafer, which comprises:
a circuit board for inspection, on the surface of which inspection electrodes have been formed in accordance with a pattern corresponding to a pattern of electrodes to be inspected of the integrated circuits formed on the wafer, which is an object of inspection, and the anisotropically conductive connector according to any one of claims 2 to 5, which is arranged on the surface of the circuit board for inspection.

7. The probe member according to claim 6, wherein the coefficient of linear thermal expansion of the frame plate in the anisotropically conductive connector is at most 3 x 10⁻⁵/K, and the coefficient of linear thermal expansion of a base material making up the circuit board for inspection is at most 3 x 10⁻⁵/K.

8. The probe member according to claim 6 or 7, wherein a sheet-like connector composed of an insulating sheet and a plurality of electrode structures each extending through the insulating sheet in a thickness-wise direction thereof and arranged in accordance with a pattern corresponding to the pattern of the electrodes to be inspected is arranged on the anisotropically conductive connector.

9. A wafer inspection apparatus for conducting electrical inspection of each of a plurality of integrated circuits formed on a wafer in a state of the wafer, which comprises the probe member according to any one of claims 6 to 8,
wherein electrical connection to the integrated circuits formed on the wafer, which is an object of inspection, is achieved through the probe member.

10. A wafer inspection method comprising a step of electrically connecting each of a plurality of integrated circuits formed on a wafer to a tester through the probe member according to any one of claims 6 to 8 to perform electrical inspection of the integrated circuits formed on the wafer.
